(19) **Europäisches Patentamt**
**European Patent Office**
**Office européen des brevets**

(11) **EP 4 715 655 A1**

(12) **EUROPEAN PATENT APPLICATION**

(43) Date of publication:
**25.03.2026 Bulletin 2026/13**

(21) Application number: **24306557.0**

(22) Date of filing: **23.09.2024**

(51) International Patent Classification (IPC):
**G06F 30/13** (2020.01)    **G06F 30/27** (2020.01)
**G06N 3/045** (2023.01)

(52) Cooperative Patent Classification (CPC):
**G06F 30/27; G06F 30/13; G06N 3/045;
G06N 3/047; G06N 3/08; G06N 3/088**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Dassault Systèmes
78140 Vélizy-Villacoublay (FR)**

(72) Inventors:
• **Maillard, Léopold
Vélizy-Villacoublay (FR)**
• **Sereyjol-Garros, Nicolas
Vélizy-Villacoublay (FR)**
• **Durand, Tom
Vélizy-Villacoublay (FR)**

(74) Representative: **Bandpay & Greuter
11 rue Christophe Colomb
75008 Paris (FR)**

(54) **NOISE-BASED 3D LAYOUT PREDICTION**

(57) The disclosure notably relates to a computer-implemented method of machine-learning. The method comprises obtaining a dataset of ground truth 3D layouts. The machine-learning method further comprises obtaining a probability distribution of noise levels. The machine-learning method also comprises, for each ground truth 3D layout, obtaining a respective perturbed 3D layout. The machine-learning method moreover comprises training a function. The function is configured for taking an input 3D layout and a given noise level, and for predicting an output 3D layout. The training is performed over the dataset based on a loss which penalizes a dissimilarity metric between each ground truth 3D layout and a respective predicted 3D layout.

(b) Visualization of the representation

(a) HomeByMe scene

**FIG. 4**

EP 4 715 655 A1

**Description**

**TECHNICAL FIELD**

The disclosure relates to the field of computer programs and systems, and more specifically to methods, data structures and systems related to 3D layout prediction.

**BACKGROUND**

Some available solutions for generation of 3D scenes involve machine-learning techniques, such as Generative Adversarial Networks (GAN).

The current prior art presents major limitations while attempting to obtain realistic and diverse scene arrangements. Realistic scene arrangement means that the scene configuration is semantically consistent among objects and between objects and floorplan, as well as physically meaningful. In other words, a realistic scene arrangement tends to promote groups of objects with strong semantic relationships among them and with the floorplan and tends to favor placing the objects in a consistent physical manner. Therefore, a realistic scene arrangement tends to discourage, for example, placing a bed in a kitchen (object semantically inconsistent with the floorplan), placing an oven next to a bed (objects semantically inconsistent between each other), and placing objects without required physical support (e.g., a tea cup floating instead of being placed on a table).

Within this context, there is still a need for an improved solution for predicting 3D layouts.

**SUMMARY**

It is therefore provided a computer-implemented method of machine-learning. The machine-learning method comprises obtaining a dataset of ground truth 3D layouts. Each ground truth 3D layout represents a respective scene. Each ground truth 3D layout includes a respective floorplan, a respective 3D arrangement of one or more 3D bounding boxes, and for each 3D bounding box, a respective semantic category. Each bounding box is defined by a value of a predetermined set of one or more parameters. The machine-learning method further comprises obtaining a probability distribution of noise levels. The machine-learning method also comprises, for each ground truth 3D layout, obtaining a respective perturbed 3D layout. The

respective perturbed 3D layout is a 3D layout computable by perturbing at least one parameter of at least one 3D bounding box of the ground truth 3D layout. The perturbing includes sampling a respective noise level based on the probability distribution. The perturbing also includes, for each respective parameter of the at least one parameter, sampling a respective noise value based on the respective noise level, and applying the respective noise value to the respective parameter. The machine-learning method moreover comprises training a function. The function is configured for taking an input 3D layout and a given noise level. The input 3D layout includes a given floorplan, a first 3D arrangement of one or more given 3D bounding boxes, and, for each given 3D bounding box, a given semantic category. Each bounding box is defined in the first 3D arrangement by a first value of the predetermined set of one or more parameters. The function is also configured for predicting an output 3D layout. The output 3D layout includes the given floorplan, a second 3D arrangement of the one or more given 3D bounding boxes, and, for each given 3D bounding box, the given semantic category. Each bounding box is defined in the second 3D arrangement by a second value of the predetermined set of one or more parameters. The function is further configured to predict a second value of the predetermined set of one or more parameters different from the first value of the predetermined set of one or more parameters. The training is performed over the dataset based on a loss which penalizes a dissimilarity metric between each ground truth 3D layout and a respective predicted 3D layout, wherein the respective predicted 3D layout is obtainable by applying the function to the respective perturbed 3D layout.

The machine-learning method may comprise one or more of the following features:

- the dissimilarity metric is of the type:

$$d(\hat{\mathcal{O}}, \mathcal{O}) = \frac{1}{2N}\left( \sum_{\hat{o} \in \hat{\mathcal{O}}} \min_{o \in \mathcal{O}} l(\hat{o}, o) + \sum_{o \in \mathcal{O}} \min_{\hat{o} \in \hat{\mathcal{O}}} l(\hat{o}, o) \right)$$

where:

• $\mathcal{O} = \{o_1, o_2, \dots, o_N\}$ is the set of the one or more 3D bounding boxes in a ground truth 3D layout,

- $\hat{\mathcal{O}} = \{\hat{o}_1, \hat{o}_2, ..., \hat{o}_N\}$ is the set of the one or more 3D bounding boxes in the respective predicted 3D layout,
  - N is the common size of $\mathcal{O}$ and $\hat{\mathcal{O}}$, and
  - $l(.,.)$ is a differentiable distance;

- the differentiable distance penalizes a dissimilarity in dimensions and/or in the semantic category between 3D bounding boxes, and for example is of the type:

$$l(\hat{o}, o) = \|\hat{x} - x\|_2^2 + K\big(1 - \delta_d(\hat{o}, o)\,\delta_c(\hat{o}, o)\big)$$

where:

- $\hat{x}$, respectively $x$, is a vector of values of spatial parameters of $\hat{o}$, respectively $o$,
  - $\|\cdot\|_2^2$ is the Euclidean norm,
  - $K$ is a penalty parameter,
  - $\delta_d(\hat{o}, o)$ is an indicator function equal to 1 when its arguments $\hat{o}$ and $o$ have same dimensions, 0 otherwise, and
  - $\delta_c(\hat{o}, o)$ is an indicator function equal to 1 when its arguments $\hat{o}$ and $o$ have a same semantic category, 0 otherwise;

- the loss of the trained function is an expectation value ($L((\hat{\mathcal{O}}, \mathcal{O}) = \mathbb{E}_\sigma\big[\lambda(\sigma)\,d\big(\hat{\mathcal{O}}, \mathcal{O}\big)\big]$) of the product ($\lambda(\sigma)\,d(\hat{\mathcal{O}}, \mathcal{O})$)) between the dissimilarity metric ($d(\hat{\mathcal{O}}, \mathcal{O})$) and a noise-dependent weighting function ($\lambda(\sigma)$);
- the function comprises a transformer which:

  - takes as input a concatenation of: a representation of the given noise-level, a first representation of each given 3D bounding box, and a representation of the given floorplan, and
  - outputs a representation of the predicted 3D layout, including a second representation of each given 3D bounding box;

- the function further comprises:

  - a noise encoder which generates the representation of the given noise level,
  - a 3D object encoder which generates the first representation of each given 3D bounding box, wherein optionally the 3D object encoder is configured for generating a respective representation of each parameter and a representation of the semantic category, and for concatenating all the generated representations, and/or
  - a floor encoder which generates the representation of the given floorplan, wherein optionally the floor encoder includes a sampling module for generating a sampling from the given floor plan, and a point-cloud encoder for processing the sampling;

- the function further includes a multilayer perceptron which takes as input the representation of the predicted 3D layout and outputs a third representation of each given 3D bounding box; and/or
- the function is parametrized as follows:

$$D_\theta(x_\sigma; y, \sigma) = c_{skip}(\sigma) * x_\sigma + c_{out}(\sigma) * S_\theta\big(c_{in}(\sigma)x_\sigma; y, c_{noise}(\sigma)\big),$$

where:

- $x_\sigma$ is the first 3D arrangement of one or more given 3D bounding boxes,
  - $y$ represents the given floorplan, the given semantic category of each of the one or more given 3D bounding boxes, and dimensions of each of the one or more given 3D bounding boxes,
  - $\sigma$ is the given noise level,
  - $S_\theta(c_{in}(\sigma)x_\sigma; y, c_{noise}(\sigma))$ is a noise-conditioned score network having a set of trainable parameters $\theta$,
  - $c_{skip}(\sigma)$ is a noise-dependent pre-conditioning coefficient modulating the predicted 3D layout,
  - $c_{noise}(\sigma)$ is a noise-dependent coefficient which conditions the noise level within the score network, and
  - $c_{in}(\sigma)$ and $c_{out}(\sigma)$ are two noise-dependent coefficients that scale, respectively, $x_\sigma$ and $S_\theta(c_{in}(\sigma)x_\sigma; y, c_{noise}(\sigma))$.

It is further provided a computer-implemented method of use of a function trained according to the machine-learning method. The method of use comprises obtaining an input 3D layout and a given noise level. The input 3D layout includes a given floorplan, a first 3D arrangement of one or more given 3D bounding boxes, and, for each given 3D bounding box, a given semantic category. Each bounding box is defined in the first 3D arrangement by a first value of the predetermined set of one or more parameters. The method of use also comprises applying the trained function one or more times starting from the input 3D layout to predict an output 3D layout. The output 3D layout includes the given floorplan, a second 3D arrangement of the one or more given 3D bounding boxes, and, for each given 3D bounding box, the given semantic category. Each bounding box is defined in the second 3D arrangement by a second value of the predetermined set of one or more parameters.

The method of use may comprise one or more of the following features:

- applying the trained function one or more times comprises iterating:

  • injecting a noise to the input 3D layout, thereby obtaining a perturbed input 3D layout;
  • applying the trained function at least once to the perturbed input 3D layout, thereby obtaining an output 3D layout; and
  • using the output 3D layout as the input of a next iteration;

- the noise has a level which decreases with the depth in the iteration; and/or
- applying the trained function at least once comprises, at each iteration:

  • applying the trained function to the perturbed input 3D layout, thereby obtaining a first output 3D layout;
  • obtaining a first intermediate 3D layout by computing a gradient step between the perturbed input 3D layout and the first output 3D layout;
  • applying the trained function to the first intermediate 3D layout, thereby obtaining a second output 3D layout; and
  • obtaining a second intermediate 3D layout by computing a gradient step between the perturbed input 3D layout and the second output 3D layout, thereby obtaining a final 3D layout.

It is further provided a data structure comprising a computer program comprising instructions for performing the machine-learning method and/or the method of use, and/or a function having been trained by the machine-learning method.

It is further provided a device comprising a data storage medium having recorded thereon the data structure.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

**BRIEF DESCRIPTION OF THE DRAWINGS**

Non-limiting examples will now be described in reference to the accompanying drawings, where:

- FIG. 1 shows a flowchart of an example of the machine-learning method;
- FIG.s 2a-2c show flowcharts of examples of the method of use;
- FIG. 3 shows a schematic representation of an example of the disclosed solution;
- FIG.s 4 to 18 illustrate the disclosed solution; and
- FIG. 19 shows an example of the system.

**DETAILED DESCRIPTION**

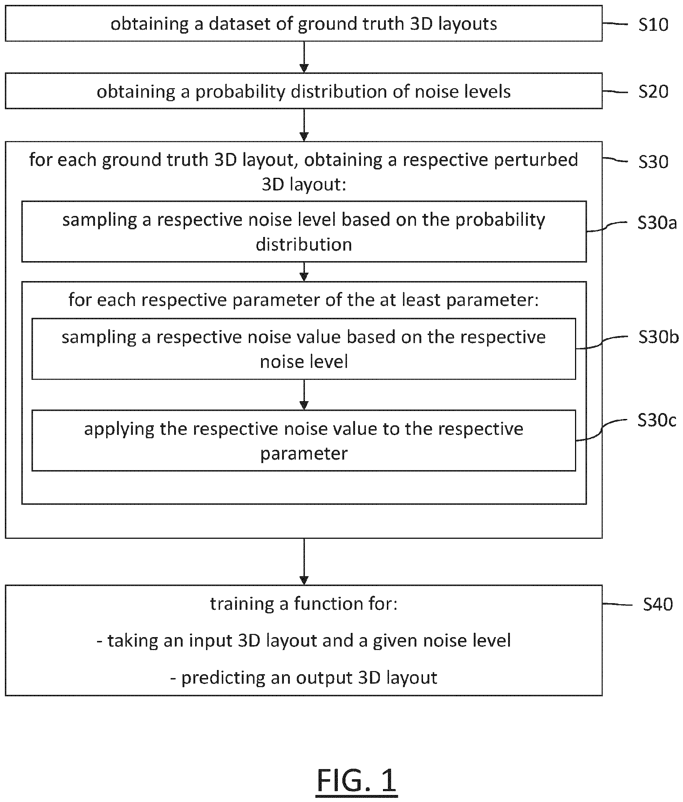

With reference to the flowchart of FIG. 1, it is proposed a computer-implemented method of machine-learning, which may serve for noise-based prediction of scene arrangements. The machine-learning method comprises obtaining S10 a dataset of ground truth 3D layouts. Each ground truth 3D layout represents a respective scene. Each ground truth 3D layout includes a respective floorplan, a respective 3D arrangement of one or more 3D bounding boxes, and, for each 3D bounding box, a respective semantic category. Each bounding box is defined by a value of a predetermined set of one or more parameters. The machine-learning method further comprises obtaining S20 a probability distribution of noise levels.

The machine-learning method also comprises, for each ground truth 3D layout, obtaining S30 a respective perturbed 3D layout. The respective perturbed 3D layout is a 3D layout computable (e.g., having been computed, e.g., the method including such computing) by perturbing (e.g., the method comprising such perturbing) at least one parameter of at least one 3D bounding box of the ground truth 3D layout. In other words, the machine-learning method may include the computation of at least one (e.g., each) respective perturbed 3D layout, and/or the retrieval (e.g., on local or distant memory) or reception (e.g., from a remote third-party computer system) of at least one (e.g., each) respective perturbed 3D layout, whereby the retrieved or received at least one respective perturbed 3D layout has been computed beforehand. The perturbing includes sampling S30a a respective noise level based on the probability distribution. The perturbing also includes, for each respective parameter of the at least one parameter, sampling 30b a respective noise value based on the respective noise level, and applying 30c the respective noise value to the respective parameter.

The machine-learning method moreover comprises training S40 (and outputting) a function. The function is configured (after the training S40) for taking an input 3D layout and a given noise level, and for predicting (i.e., outputting or generating) an output 3D layout.

The input 3D layout includes a given floorplan, a first 3D arrangement of one or more given 3D bounding boxes, and, for each given 3D bounding box, a given semantic category. Each bounding box is defined in the first 3D arrangement by a first value of the predetermined set of one or more parameters. The output 3D layout includes the (same) given floorplan, a second 3D arrangement of the (same) one or more given 3D bounding boxes, and, for each given 3D bounding box, the (same) given semantic category. Each bounding box is defined in the second 3D arrangement by a second value of the predetermined set of one or more parameters. The function is configured to predict a second value of the predetermined set of one or more parameters which is different from the first value of the predetermined set of one or more parameters (the given floorplan, the given noise level and the given semantic category of each given 3D bounding box are constants of the function, i.e., the function does not change their value, but the predetermined set of one or more parameters in the 3D arrangement of the one or more given 3D bounding boxes are authorized to vary, i.e., the function may change their value).

The training is performed over the dataset based on a loss which penalizes a (same) dissimilarity metric between each ground truth 3D layout and a respective predicted 3D layout, wherein the respective predicted 3D layout is obtainable (i.e., can be obtained) by applying the function to the respective perturbed 3D layout.

Such a machine-learning method forms an improved solution for predicting 3D layouts.

Notably, the function is trained at S40 to become a denoiser, which is able to denoise the input 3D layout such that it is transformed in an output predicted 3D layout which is more realistic. The function trained at S40 is also flexible, meaning that the trained function can be used to perform different tasks, as discussed afterwards.

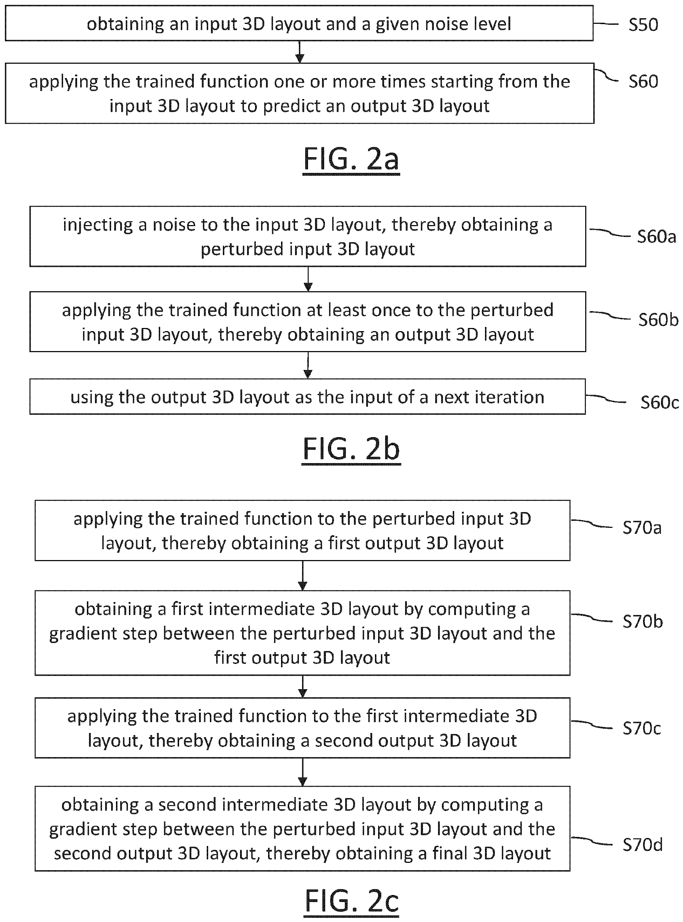

With reference to the flowchart of FIG. 2a, the function can thus be used in a computer-implemented method of use, which comprises obtaining S50 an input 3D layout and a given noise level. The input 3D layout includes a given floorplan, a first 3D arrangement of one or more given 3D bounding boxes, and, for each given 3D bounding box, a given semantic category. Each bounding box is defined in the first 3D arrangement by a first value of the predetermined set of one or more parameters. The method of use also comprises applying S60 the trained function one or more times, starting from the input 3D layout, to predict an output 3D layout. In other words, the trained function is first applied to the input 3D layout, and the trained function may then optionally be applied one or more additional times, each time on an input obtained based on the previous output of the trained function. The output 3D layout (eventually predicted, i.e., after the or all application(s) of the function) includes the given floorplan, a second 3D arrangement of the one or more given 3D bounding boxes, and, for each given 3D bounding box, the given semantic category. Each bounding box is defined in the second 3D arrangement by a second value of the predetermined set of one or more parameters.

Thanks to the function having been learnt according to the machine-learning method of FIG. 1, the output 3D layout obtained from S60 is a more realistic version of the input 3D layout provided at S50.

Indeed, the machine-learning method uses a data-driven approach which allows the function to learn arrangement patterns and relationships among objects and between objects and the constrained environment to predict realistic 3D layouts. In other words, the data-driven approach of the machine-learning method allows the trained function to learn the interactions (i.e., relations) among 3D objects (i.e., the semantic consistency) and between 3D objects and the constrained environment (i.e., the spatial reasoning) solely from the training dataset.

In examples, the training dataset obtained at S10 may include realistic and diverse ground truth 3D layouts, each ground truth 3D layout representing a 3D scene. The 3D scenes may be obtained from digital 3D scenes dataset and/or from real-world 3D scenes. An example of a digital 3D scene dataset may be the HomeByMe® dataset or any subset thereof which may contain at least a thousand scenes (e.g., 10K scenes) that are densely furnished, e.g., containing at least 20 objects.

The machine-learning method is moreover trained over the dataset based on a loss that penalizes dissimilarities between a ground truth 3D layout and a respective predicted 3D layout. In particular, such a loss may be invariant under permutations of identical 3D objects. Such an option may facilitate the training and may avoid penalizing predicted 3D layouts where identical objects are interchanged with respect to the ground truth 3D layout, thus enforcing the diversity of the 3D scene generation.

In addition, the machine learning method adopts a denoising approach to generate the predicted output. The denoising approach has better performances with respect to other classes of existing generative models, such as GAN models. The machine-learning method includes the injection of different noise levels based on an obtained probability distribution to perturb the samples of the training dataset. In addition, the model (i.e., denoiser) is "noise-conditioned", in the sense that it is configured to be applied to an input sample with a given value of noise level (i.e., the noise level is given as input to the model, as a "condition"). Such a noise-based approach allows the trained function to learn from the perturbed (i.e., noisy) dataset, thus providing the trained function with the remarkable ability to denoise the input and predict realistic and diverse 3D scene arrangements. Said differently, the machine-learning method may train a function which best "denoises" the input 3D layout at any (i.e., arbitrary) noise level to predict realistic (i.e., natural-looking) 3D layouts.

Furthermore, the denoising-based approach improves the 3D arrangement of densely furnished scenes such as real-life scene arrangements, i.e., the trained function predicts more realistic and diverse 3D scenes containing numerous (e.g., at least 20) objects (compared, for example, to autoregressive methods that would predict arrangements where the objects are inserted sequentially, i.e., one-at-a-time). In examples, the proposed method generates plausible (e.g., realistic and diverse) 3D arrangements for scenes which are well-furnished containing at least 20 objects, showing the advantage of being scalable to at least 50 objects. The dataset obtained at S10 may comprise ground truth 3D layouts containing at least 20 objects and/or ground truth 3D layouts containing at least 40 objects. Respectively, the input 3D layout obtained at S50 may contain at least 20 objects or at least 40 objects. The proposed method, in fact, achieves better (i.e., more accurate) results in terms of physical consistency and realism of predicted 3D layouts, because the denoising approach allows the trained function to learn 3D objects relationships at the same time, i.e., to acquire the nontrivial interdependence among 3D objects and between each 3D object and the given floorplan, e.g., with self-attention mechanisms. At the same time (i.e., simultaneously) means that during the training of a function S40, the first value of the predetermined set of one or more parameters of each 3D bounding box in the first 3D arrangement may be inputted at the same time. Said differently, the function may take as input all 3D objects in the input 3D layout at the same time. In other words, the trained function captures all the spatial and semantic relationships to obtain realistic and diverse scene arrangements. Likewise, the second value (i.e., the value predicted by the function) of the predetermined set of one or more parameters of each 3D bounding box in the second 3D arrangement may be also outputted at the same time (instead of one object after the other, e.g., one object at a time). Such a simultaneous processing of the one or more parameters of each 3D bounding box amounts to a better object grouping, i.e., the ability of the function to identify objects that may be associated together in the predicted 3D arrangement.

As shown in the flowchart of FIG. 2b, the applying S60 of the function (trained at S40) one or more times may optionally comprise injecting S60a a noise to the input 3D layout, thereby obtaining a perturbed input 3D layout, applying S60b the trained function at least once to the perturbed input 3D layout, thereby obtaining an output 3D layout (e.g., either (i) as the direct result of the application one time of the trained function, or (ii) as a result obtained by the application one time of the trained function and then processing the obtained output, or (iii) as a result obtained by the application several times of the trained function, each time starting from the direct result of the application the previous time of the trained function or from a result obtained by the application the previous time of the trained function and then processing the obtained output), and, using S60c the output 3D layout as the input of a next iteration.

Thus, the method of use may form a denoising diffusion model. Such a model allows to reach an accurate and realistic 3D layout throughout an iterative sampling process (i.e., an iterative denoising). The iterative sampling amounts to the application S60 of the trained function one or more times starting from the input 3D layout to predict an output 3D layout. The iterative sampling approach allows the trained function to improve the quality of the predicted 3D arrangements. In other words, the predicted 3D arrangements amount to more natural-looking 3D arrangements showing an improved quality of realism and diversity of the 3D scenes.

Moreover, the method of use may amount to a time-efficient iterative sampling process with a trade-off between the sampling time and the quality of the predicted 3D layouts that may be set by a user. In examples, the method of use may support efficient batching techniques and/or parallelization capabilities (e.g., on GPUs) to generate 3D scene arrangements for multiple scenes and/or multiple arrangements of a single scene in a single iterative sampling process.

Furthermore, the trained function may be applied one or more times within an iterative process with a decreasing noise level at each iteration. In particular, at each iteration, the injection of a noise S60a to the input 3D layout may include a noise level scheduling, wherein the injected noise has a level that may decrease with the depth in the iteration. Such a noise level scheduling allows for an improvement of the quality of the predicted 3D layouts. The trained function, during the inference phase, is thus best optimized to denoise an input 3D layout that has been perturbed at different noise levels. In other words, the trained function being noise-conditioned, has the ability to denoise the input 3D layout to generate (i.e. predict) realistic 3D layouts.

The method of use makes the most of the flexibility of the trained function, which may be used in different applications. The method of use may, for example, be implemented for 3D arrangement generation, partial 3D arrangement generation, 3D re-arrangement and/or 3D objects grouping of a list of objects within a given floorplan. In particular, the iterative denoising may be adapted according to the specific application.

For instance, in the 3D arrangement generation, the 3D object positions are arbitrarily initialized at the center of the room and the 3D object rotations and/or dimensions are randomly initialized. In such example, the iterative denoising starts from a sufficiently high noise level and is performed for at least 30 steps, thus producing a fair compromise between the quality of the predicted 3D arrangement and the sampling time.

In the partial 3D arrangement generation application, some 3D objects already have their positions and/or dimensions and/or rotation values known. These objects are therefore initialized to their known values, whereas the object to be arranged have positions initialized to the center of the room and rotations randomly initialized. At each denoising step, the output of the model for the known 3D objects (i.e., the 3D objects with known values of their positions and rotations parameters) may be replaced by their original position and orientation (i.e., rotation) values. Note that, the output of the model for the known 3D objects may be replaced by their perturbed position and rotation values that have been noised at a level corresponding to the current sampling step. Either case, these known objects ultimately converge to their initial values throughout the sampling process.

In another application, such as 3D re-arrangements, the 3D object positions and rotations are initialized to their noisy (i.e., perturbed) values. The denoising process may be performed starting from a value of the noise level that is lower than for the task of 3D arrangement generation.

The function trained according to S40 takes as input a 3D layout and a given noise level.

Each 3D layout is a set of data that includes a given floorplan, a 3D arrangement of one or more 3D bounding boxes, and, for each 3D bounding box, a respective semantic category. In other words, a 3D layout represents the arrangement of one or more 3D bounding boxes within a given floorplan. A 3D bounding box of a 3D object is a smallest rectangular cuboid that encloses the 3D object; with or without orienting constraints (such as a constraint that the cuboid must have a face parallel to a horizontal plane). A 3D bounding box is, thus, characterized by its spatial attributes, (i.e., its position, its dimensions, and optionally its -unconstrained- orientation parameters) and by its semantic category (i.e., a class of objects, e.g., having the same function, e.g., a book, a chair, etc.). The predetermined set of one or more parameters may describe the spatial attributes of a 3D object. Each object spatial attribute may have an individual real-world interpretation. In examples, the predetermined set of one or more parameters may include the 3D position coordinates, the three dimensions (i.e., height, depth and length), and at least one parameter representing the orientation of the object (e.g., cosine and sine of an angle around the vertical axis). Thus, the predetermined set of one or more parameters may comprise or consist of eight parameters. The use of 3D bounding boxes captures the three-dimensional positionings of 3D objects. Therefore, thanks to the use of 3D bounding boxes, the trained function predicts precise and realistic 3D positioning and sizing of 3D objects. In particular, the trained function, and consequently the method of use, predicts 3D layouts that show physically consistent positionings in three dimensions, thus avoid subtle flaws that break the perceived validity of the overall scene, such as overlapping, floating or out-of-bound objects, inaccessible areas and inconsistent objects positioning.

A floorplan is data that describe the plan of the scene wherein the 3D objects may be arranged, i.e., it represents the corners of the room. Therefore, a floorplan sets the boundary of the 3D scene arrangement and it conditions the 3D output layout. The floorplan may be obtained at S10 from external 3D databases in the machine learning method. During the training, the floorplan may be rotated by a random angle along the vertical axis. The floorplan inputted at S50 in the method of use may be imported from the real world by means of 3D scanning technologies.

Likewise, the 3D objects may be obtained at S10 from external database and/or from an online catalog in the machine learning method. During the inference, the 3D objects inputted at S50 in the method of use may be imported from the real world.

Additionally or alternatively, the method of use may comprise further arranging a real-world room according to the predicted layout, i.e., each 3D object eventually has a corresponding real-world physical object positioned and oriented in the real-world room according to the predicted layout. Thus, the method of use may reproduce various and realistic 3D scene arrangements that can be realized in the user's home/apartment in the real world. In other words, the method of use is user-driven, i.e., the method facilitates real-life user interactions to generate 3D layouts that resemble real-world 3D scenes (e.g., in a design planner application). For example, a user may design a floorplan and select a list of 3D objects to generate several 3D layouts and, eventually, select an output (e.g., an output with a 3D arrangement that best suits the purposes of an interior design). In an example of the method of use, a user may input their floorplan (e.g., from their house or apartment) together with a list of furniture (i.e., a list of semantic categories of 3D objects to be arranged) to get various 3D arrangements. In another scenario, the user may want to re-arrange a 3D scene already furnished by selecting some 3D objects to be rearranged and the others are kept fixed at their positions.

The given noise level is sampled S30a from an obtained probability distribution in the machine learning method, while it is obtained (i.e., provided) S50 in the method of use. In examples, the probability distribution obtained at S20 may be a Gaussian distribution.

During the training, the noise level is introduced to perturb the dataset, i.e., for each ground truth 3D layout a respective perturbed 3D layout is obtained and/or computed. High levels of noise mean that the perturbed 3D layout is "far" from the ground truth 3D layout; low levels of noise mean that the perturbed 3D layout is "close" to the ground truth 3D layout. In other words, the machine learning method, for each ground truth 3D layout, comprises obtaining S30 a respective perturbed 3D layout by sampling S30a different noise levels based on the probability distribution, and, for each respective parameter of the at least one parameter, sampling at S30b different noise values based on the respective noise levels and applying S30c the respective noise value to the respective parameters of each of the one or more 3D bounding boxes in the 3D arrangement. The function acquires, therefore, the ability to predict 3D scenes that have been perturbed at different noise levels.

The obtaining S30 of at least one (e.g., each) respective perturbed 3D layout obtained may comprise perturbing at least one parameter of at least one (e.g., each) 3D bounding box of the ground truth 3D layout, or retrieving (e.g., on local or distant memory) or receiving (e.g., from a remote computer) the result of such perturbing. The perturbing includes sampling S30a a respective noise level based on the probability distribution within a real interval. The noise level is a positive (e.g., real) number. The noise level may be the magnitude at which the parameters of the 3D bounding boxes (i.e., the spatial attributes) are generally perturbed. The noise level may be the absolute value of a scalar drawn from the probability distribution. In examples, a noise level may be drawn from a Gaussian distribution $\sigma = abs[N(0, \sigma_s)]$, where $\sigma_s$ may for example be higher than 0.1 and/or lower than 0.5 (such as $\sigma_s = 0.23$) and may be set experimentally so that, during the inference phase, the trained model is able to predict 3D arrangements from configurations perturbed with both sufficiently low and high levels of noise. The perturbing further includes, for each respective parameter of the at least one parameter, sampling S30b a respective noise value based on the respective noise level (e.g., $\varepsilon = N(0, 1)$) and applying S30c the respective noise value (e.g., $\varepsilon\sigma$) to the respective parameter (e.g., the respective parameter $p$ is perturbed as $p_\sigma = p + \varepsilon\sigma$).

The obtained dataset S10 of ground truth scenes may additionally be augmented by a random rotation of the scenes along the vertical axis; this random data augmentation may help improving the training to predict arrangement scenes with walls not aligned with at least one coordinate axis.

The function is trained at S40 to be configured for taking as input a 3D layout and a given noise level. The input 3D layout includes a given floorplan, a first 3D arrangement of one or more given 3D bounding boxes and for each given 3D bounding box, a given semantic category. Each bounding box is defined in the first 3D arrangement by a first value of the predetermined set of one or more parameters. Said differently, in the given floorplan, each 3D bounding box (that is labelled by a semantic category) may be defined by a first value of its spatial attributes that define its position, dimensions and orientation in the scene.

The function is configured for predicting an output 3D layout. The output 3D layout includes the given floorplan, a second 3D arrangement of the one or more given 3D bounding boxes and, for each given 3D bounding box, the given semantic category. Each bounding box is defined in the second 3D arrangement by a second value of the predetermined set of one or more parameters. The function is further configured to predict a second value of the predetermined set of one or more parameters different from the first value of the predetermined set of one or more parameters. The given floorplan and the given semantic category of each given 3D bounding box may be constants of the function, i.e., the function does not change their value. By "a second 3D arrangement of the one or more given 3D bounding boxes", it is meant that the one or more given 3D bounding boxes may be arranged within the same given floorplan, in a way that the predicted second value of its spatial attributes is different from the first value of the spatial attributes (i.e., the input). In other words, the trained function predicts a second value of positions, dimensions and orientation of the 3D bounding boxes, thus predicting a second 3D arrangement of the one or more 3D bounding boxes. The other variables of the function may remain constant, namely the predicted 3D arrangement may be performed in the same given floorplan and with the same list of given semantic categories.

In other words, the function is trained at S40 to only re-arrange (i.e., using repositioning and/or re-sizing and/or re-orienting) the 3D bounding box(es) of the input 3D layout.

The training of the function is performed over the training dataset (e.g., HomeByMe®'s dataset) of ground truth 3D layouts and it is based on a loss which penalizes a dissimilarity metric between each ground truth 3D layout and a respective predicted 3D layout obtainable by applying the function to the respective perturbed 3D layout. The respective perturbed 3D layout may be fed as input of the trained function to obtain the respective predicted 3D layout. Therefore, the training loss may evaluate the "distance" between each ground truth 3D layout and the respective predicted 3D layout. The training loss may privilege the predicted 3D layout "closer" to the ground truth 3D layout.

In examples, the dissimilarity metric may be of the type:

$$d\left(\hat{\mathcal{O}}, \mathcal{O}\right) = \frac{1}{2N}\left(\sum_{\hat{o} \in \hat{\mathcal{O}}} \min_{o \in \mathcal{O}} l(\hat{o}, o) + \sum_{o \in \mathcal{O}} \min_{\hat{o} \in \hat{\mathcal{O}}} l(\hat{o}, o)\right)$$

where:

- $\mathcal{O} = \{o_1, o_2, \ldots, o_N\}$ is the set of the one or more 3D bounding boxes in a ground truth 3D layout,

- $\widehat{\mathcal{O}} = \{\hat{o}_1, \hat{o}_2, ..., \hat{o}_N\}$ is the set of the one or more 3D bounding boxes in the respective predicted 3D layout,
  - N is the common size of $\mathcal{O}$ and $\widehat{\mathcal{O}}$, and
  - $l(.,.)$ is a differentiable distance (e.g., the Euclidean distance).

Such a dissimilarity metric thus amounts to a Chamfer distance which measures the dissimilarity between sets of bounding boxes. In such examples, the dissimilarity metric measures the distance between the set of one of more 3D bounding boxes in a ground truth 3D layout $\mathcal{O}$ and the set of one or more 3D bounding boxes in the respective predicted 3D layout $\widehat{\mathcal{O}}$. In examples, the common size N of the sets $\mathcal{O}$ and $\widehat{\mathcal{O}}$ may contain at least 20 objects (e.g., 50 objects to be arranged). The proposed method, therefore, allows the realistic and precise arrangements of densely-furnished scenes. In other words, the proposed solution amounts to a scalable method that is adapted to arrange several items (e.g., at least 20 objects). In addition, the Chamfer distance is more efficient compared to other methods for set comparison (e.g., more efficient than the Earth Mover's distance).

The dissimilarity metric may feature a differentiable distance $l(.,.)$ that is computationally efficient. In fact, the training S40 may comprise evaluations of the differentiable distance, and each evaluation may be parallelized on GPUs. In particular, the training S40 may comprise executing parallel sessions, wherein each session comprises the parallel evaluation of the differentiable distance between each 3D bounding box of the set of one or more 3D bounding boxes in the ground truth 3D layout and the set of one or more 3D bounding boxes in the respective predicted 3D layout. Such a parallelization allows time and resource efficiency.

The differentiable distance may penalize a dissimilarity in dimensions and/or in the semantic category between 3D bounding boxes, and for example may be of the type:

$$l(\hat{o}, o) = \|\hat{x} - x\|_2^2 + K\big(1 - \delta_d(\hat{o}, o)\,\delta_c(\hat{o}, o)\big)$$

where:

- $\hat{x}$, respectively $x$, is a vector of values of spatial parameters of $\hat{o}$, respectively $o$,
- $\|.\|_2^2$ is the Euclidean norm,
- $K$ is a penalty parameter,
- $\delta_d(\hat{o}, o)$ is an indicator function equal to 1 when its arguments $\hat{o}$ and $o$ have same dimensions, 0 otherwise, and
- $\delta_c(\hat{o}, o)$ is an indicator function equal to 1 when its arguments $\hat{o}$ and $o$ have a same semantic category, 0 otherwise.

In examples, for each pair of 3D bounding boxes, one within the set of one or more 3D bounding boxes in the ground truth 3D layout and the other one within the set of one or more 3D bounding boxes in the respective predicted 3D layout, the differentiable distance may compute the Euclidean norm between the values of their spatial parameters (e.g., the spatial attributes such as position and orientation). The differentiable distance may also evaluate the dissimilarity in dimensions and/or in semantic categories between the pair of 3D bounding boxes. Therefore, the dissimilarity distance may be named "semantic-aware dissimilarity distance" (e.g., semantic-aware Chamfer distance), because it is aware of (i.e., it takes into account) the semantic category associated with each 3D bounding box when evaluating the dissimilarity between 3D bounding boxes. As a consequence, if a pair of 3D bounding boxes do not share the same spatial dimensions and the same semantic category, a penalty may be applied. The penalty parameter $K$ may be set, in examples, higher than $10^4$ or $10^6$, such as $K = 10^8$.

The loss based on which the training S40 of the function over the dataset is performed may be an expectation value of the type $L(\widehat{\mathcal{O}}, \mathcal{O}) = \mathbb{E}_\sigma\big[\lambda(\sigma)\,d(\widehat{\mathcal{O}}, \mathcal{O})\big]$, i.e. expectation of the product between the dissimilarity metric $d(\widehat{\mathcal{O}}, \mathcal{O})$ and a noise-dependent weighting function $\lambda(\sigma)$. The presence of the weighting function facilitates the training phase across different noise levels. In examples, the noise-dependent weighting function $\lambda(\sigma)$ may be chosen, e.g., to get a uniform weighting across noise levels. More precisely, the training loss may evaluate the differences between the ground truth 3D arrangement and the predicted second 3D arrangement of the one or more 3D bounding boxes. The differences may be evaluated among the spatial attributes and the semantic categories of the 3D bounding boxes in the ground truth scene and in the predicted scene. The dissimilarity metric may compute the Euclidean distance between positions and orientations of 3D bounding boxes in the ground truth scene and in the predicted scene, and additionally compare dimensions and semantic categories of 3D bounding boxes in the ground truth scene and in the predicted scene. Therefore, the training loss may avoid penalizing predictions where objects with equal dimensions and sharing the same semantic category are exchanged in comparison to the ground truth scene.

The trained function may comprise an architecture including a (noise-aware) transformer. Transformers are a type of deep neural networks architecture, which possess remarkable ability to perceive relationships among elements within an input sequence. Thanks to a mechanism called self-attention, transformers make it possible for the function to learn the relevance of each element to the others, and to weigh the contextual information appropriately. Transformer modules take as input a sequence and output a new vector representation of the input data, in which relations within the input sequence are emphasized.

The use of a transformer allows the function to learn how to capture physical and semantic relationships between 3D objects of a scene and between each 3D object and the given floorplan, so as to predict scenes of high realism and physical plausibility. In examples, the trained function computes attention scores between each 3D bounding box of the predicted 3D layout. In examples, the transformer may take as input a concatenation of equal-length representations (i.e., embeddings, for example in $\mathbb{R}^{768}$). In particular, the transformer may take a concatenation of a representation of the given noise-level, a first representation of each given 3D bounding box, and a representation of the given floorplan. By "representation" is meant the way the input data (e.g., the noise level, the floorplan and the spatial attributes of the 3D bounding boxes) is formatted and structured so that it can be processed by the transformer (e.g., using a Positional Encoding (PE) and/or a trainable Multilayer Perceptron (MLP)). Representations may take the form of tokens. By "concatenation" is meant the combination of vectors (respectively, tensors and/or tokens) to form a new vector (respectively, tensor and/or token). The transformer may output a representation of the predicted 3D layout, including a second representation of each given 3D bounding box.

The function may further comprise encoders to generate the (e.g., equal-length) representations taken as input by the transformer. In examples, the function may comprise a noise encoder which generates the representation of the given noise level. Hereafter is detailed how the noise encoder generates the representation. The given (e.g., sampled) noise level scalar value may be passed through a PE which deterministically increases the dimension of the scalar value from $\mathbb{R}^1$ to $\mathbb{R}^{64}$. PE may enable the generation of diverse representations of the same scalar, thus allowing deep learning models to capture more nuanced information when necessary. In examples, a PE may be of the type:

$$PE(x) = \left\{ sin\left(128^{\frac{j}{31}}x\right), cos\left(128^{\frac{j}{31}}x\right) \right\}_{j=0}^{31} \in \mathbb{R}^{64}$$

In examples, the PE may project a scalar value to a 64-dimensional vector space using sinusoidal functions. The positional encoding module may be followed by a trainable MLP, that further may map the encoding to a higher dimensional vector space (e.g., from $\mathbb{R}^{64}$ to $\mathbb{R}^{768}$). The output of the noise encoder may be a token representing the noise level at which spatial attributes of 3D bounding boxes have been perturbed.

The function may comprise a 3D object encoder which generates the first representation of each given 3D bounding box. The 3D object encoder may be optionally configured for generating a respective representation of each parameter and a representation of the semantic category, and for concatenating all the generated representations. In examples, the value of the one or more parameters of each 3D bounding box in the scene may be passed through a PE, so that each value may be represented by a vector in $\mathbb{R}^{64}$. Therefore, the three positions and the three dimensions may be represented by a vector in $\mathbb{R}^{192}$. The values of the orientation, after being passed through a PE, may be additionally passed through a MLP. This additional step allows the values of the orientation to be weighted similarly to the values of the other spatial parameters, thus improving the convergence of the learning function. The semantic category of each given 3D bounding box may be passed through an MLP which generates the representation of the semantic category of each given 3D bounding box. The generated representation of the each parameter and the generated representation of the semantic category of each given 3D bounding box may be concatenated (e.g., to represent a token embedded in $\mathbb{R}^{768}$).

The function may further comprise a floor encoder which generates the representation of the given floorplan. The floor encoder may include a sampling module for generating a sampling of the given floorplan. The floor (i.e., the floorplan) is a representation of the corners of the room. The sampling module may additionally compute points (e.g., at least 100 points) along the walls of the floorplan (i.e., the room) so that the borders of the floorplan are represented by a 3D point cloud which is a standard data type that is easier to be encoded in deep learning networks.

During training, data augmentation may be performed by rotating the scenes along the vertical axis by random angles. Data augmentation helps reducing overfitting of the training data and gets a model that is more robust to learn complex floorplan geometries.

The floor encoder may also include a point-cloud encoder. In examples, a point-cloud encoder may be a PointNet. The 3D point cloud of the sampled given floorplan is then fed to the point-cloud module (e.g., the PointNet module) which outputs an embedding vector representing the given floorplan. The floor encoder may include an MLP which takes as input the embedding vector of the given floorplan and outputs the representation (e.g., token representation in $\mathbb{R}^{768}$ ) of the given floorplan.

The function may further include an MLP which takes as input the representation of the predicted 3D layout (i.e., said -high dimensional-representation being the output of the transformer) and outputs a third representation of each given 3D bounding boxes. Any further processing of the third representation of each given 3D bounding boxes may be deterministic, i.e., it does not involve any neural training. The third representation of each given 3D bounding boxes may represent the predicted position, dimensions and orientation (e.g., in $\mathbb{R}^{8}$ ) of each 3D bounding box in the predicted scene.

During the training phase, the function may be parametrized by a noise-conditioned denoiser. The parametrization may be of the type:

$$D_\theta(x_\sigma; y, \sigma) = c_{skip}(\sigma) * x_\sigma + c_{out}(\sigma) * S_\theta\big(c_{in}(\sigma)x_\sigma; y, c_{noise}(\sigma)\big),$$

where:

- $x_\sigma$ represents the first 3D arrangement of one or more given 3D bounding boxes (in a perturbed 3D layout considered as input of the function during the training),
- $y$ ($y = (\mathcal{F}, c, d)$) represents the given floorplan ($\mathcal{F}$), the given semantic category (c) of each of the one or more given 3D bounding boxes (each given semantic category being associated to the given 3D bounding boxes), and dimensions (d) of each of the one or more given 3D bounding boxes,
- $\sigma$ is the given noise level,
- $S_\theta(c_{in}(\sigma)x_\sigma; y, c_{noise}(\sigma))$ is a noise-conditioned score network having a set of trainable parameters $\theta$,
- $c_{skip}(\sigma)$ is a noise-dependent pre-conditioning coefficient modulating the predicted 3D layout,
- $c_{noise}(\sigma)$ is a noise-dependent coefficient which conditions the noise level within the score network, and
- $c_{in}(\sigma)$ and $c_{out}(\sigma)$ are two noise-dependent coefficients that scale, respectively, $x_\sigma$ and $S_\theta(c_{in}(\sigma)x_\sigma; y, c_{noise}(\sigma))$.

Such a parametrization facilitates the training of the function and helps the function to learn (i.e., to capture) relationships between the perturbed and clean configurations.

The noise-conditioned denoiser $D_\theta(x_\sigma; y, \sigma)$, that parametrizes the trained function, may take as input the perturbed spatial attributes represented by the vector $x_\sigma$. The noise-conditioned denoiser may also take as input the given noise level and additional conditioning inputs. The additional conditioning inputs $y = (\mathcal{F}, c, d)$ may represent the given floorplan, the given semantic category of each of the one or more given 3D bounding boxes and the spatial dimensions of each of the one or more given 3D bounding boxes. The noise-conditioned denoiser may output the predicted 3D layout. The denoiser network may be noise-conditioned as the network has knowledge to predict a "clean" configuration (i.e., a precise and diverse scene arrangement) from a "messy" configuration (i.e., a perturbed scene arrangement) by performing a major object arrangement (for perturbations with high level of noise)

or a minor objects arrangement (for perturbations with low level of noise). Such a feature provides the so-trained function with the ability to denoise a perturbed configuration at any (e.g., arbitrary) noise level.

The parametrization of the noise-conditioned denoiser may include a noise-conditioned score network $S_\theta$ having a set of trainable parameters $\theta$. Score-based generative models are a class of deep generative models that employs a neural network to learn the score (i.e., the gradient of log probability density function) of a noise level dependent marginal distribution obtained by perturbing training samples with noise (e.g., Gaussian) at different levels. In other words, score-based generative models are trained to model a data distribution by denoising samples that have been perturbed at different noise levels. The parameterization of the score-based objective may be carefully designed to facilitate learning the underlying data distribution. This parametrization may involve performing noise-dependent modulation of the score network's output, as well as scaling of the model's inputs, outputs and noise level. Indeed, the noise-conditioned score network may take as input the rescaled vector $c_{in}(\sigma)x_\sigma$, where $c_{in}(\sigma)$ is a noise-dependent coefficient. The noise-conditioned score network may also take as input the noise-dependent coefficient $c_{noise}(\sigma)$, which conditions the noise level within the score network. Additionally, the noise-conditioned score network may be conditioned by the conditioning inputs $y = (\mathcal{F}, c, d)$, representing the given floorplan, the given semantic category and the spatial dimensions of each of the one or more given 3D bounding boxes. The output of the noise-conditioned score network $S_\theta(c_{in}(\sigma)x_\sigma; y, c_{noise}(\sigma))$ may also be rescaled by another noise-dependent coefficient $c_{out}(\sigma)$. In examples, the coefficients may be set as follows:

$$c_{skip} = \frac{\sigma_{data}^2}{\sigma_{data}^2 + \sigma^2}, \quad c_{in} = \frac{1}{\sqrt{\sigma_{data}^2 + \sigma^2}}, \quad c_{out} = \frac{\sigma \cdot \sigma_{data}}{\sqrt{\sigma_{data}^2 + \sigma^2}}, \quad c_{noise} = \frac{\log \sigma}{4}.$$

In the above formulae, $\sigma_{data}$ is the standard deviation of the training dataset and is computed before the training phase.

Referring back to the flowchart of FIG. 2b, the application S60b of the trained function at least once may comprise, at each application of the trained function, an implementation of a $2^{nd}$ order sampling, as now described.

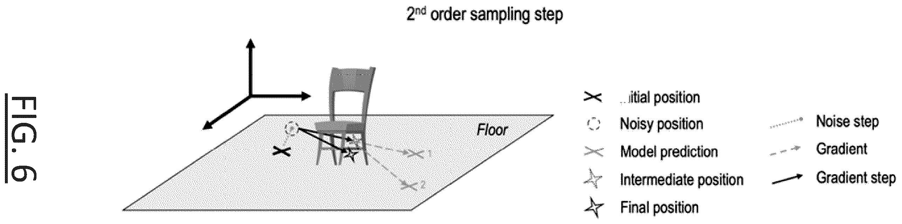

With reference to the flowchart of FIG.2c, the trained function may be applied S70a to the perturbed input 3D layout, thereby obtaining a first output 3D layout. Second, a first intermediate (e.g., middle) 3D layout may be obtained S70b by computing a gradient step between the perturbed input 3D layout and the first output 3D layout. Next, the trained function may be applied S70c to the first intermediate 3D layout, thereby obtaining a second output 3D layout. Finally, a second intermediate (e.g., middle) 3D layout may be obtained S70d by computing a gradient step between the perturbed input 3D layout and the second output 3D layout, thereby obtaining a final 3D layout. Steps from S70a to S70d are called $2^{nd}$ order sampling steps, because these steps are performed at each iteration within the iterative sampling. The implementation of the $2^{nd}$ order sampling steps improves the generation of precise and natural-looking 3D scenes while reducing the number of computationally costly neural evaluations (i.e., the applications of the function). From a 3D object placed at some initial position, by applying a noise step (i.e., applying the perturbing method of the machine-learning method), a perturbed 3D object may be obtained. The perturbed 3D object is placed at its respective noisy position. First, the function may be applied to the perturbed 3D object, thereby obtaining a first model prediction where the 3D object may be placed at a first predicted position. Second, a first intermediate position (e.g., middle) may be computed by applying a gradient step between the noisy position and the first predicted position. Next, the trained function may be applied to the 3D object placed at the computed intermediate position, thereby obtaining a second model prediction where the 3D object is placed at a second predicted position. Finally, a second intermediate (e.g., middle) position may be computed by applying a gradient step between the noisy position and the second predicted position, thereby obtaining a final predicted position. An example of visual representation of steps S70a-S70d is depicted in FIG. 6.

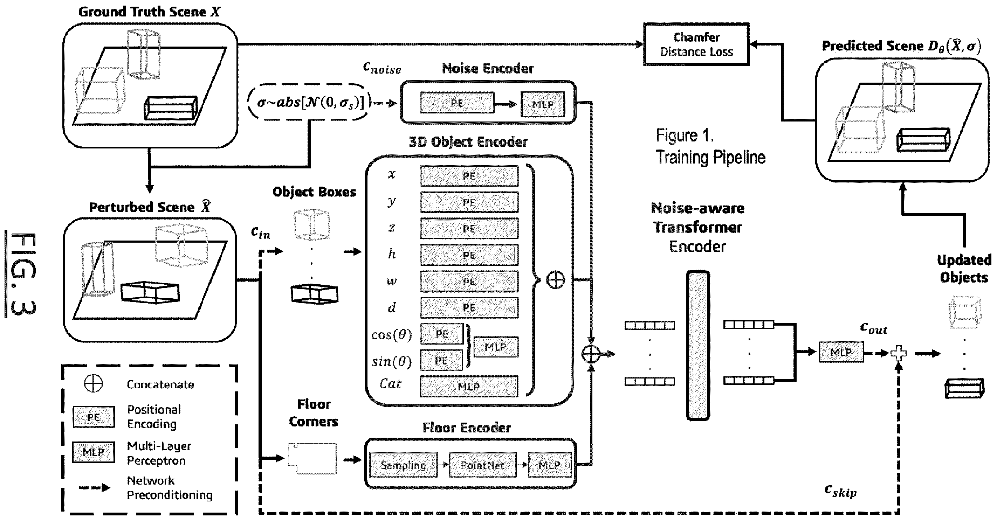

FIG. 3 shows an example of the training solution and of the neural network architecture.

Notably, FIG. 3 features a transformer encoder denoiser network that may take as input (i.e., is conditioned on) learned encoded representations of the noise level (i.e., magnitude) $\sigma$ being used to perturb the input scene (therefore qualifying the denoiser as being noise aware), its 3D objects with some of their features being perturbed (e.g., position and rotation attributes or position, rotation and bounding box dimensions, etc.), and additional scene-level conditioning features such as the room's floorplan / shape. It may output a predicted clean 3D objects layout. Like other deep learning models, the proposed one features an offline stage (training) and an online stage (generation, also called sampling or inference).

The objective of the offline training stage is to simultaneously train the distinct modules so that the denoiser / score network efficiently recovers valid 3D object spatial features from ones that have been perturbed at various magnitudes. Since the model may be conditioned on the noise scale, it knows how "far" the input noisy spatial configuration is from the target one, and if it predicts a "clean" configuration from a fully destroyed signal (high noise scale) or only model a subtle mismatch to fine tune the input objects layout (low noise scale). This training phase may be facilitated by a carefully designed pre-conditioning of the denoising pipeline and an efficient semantic-aware Chamfer Distance training objective. Random data augmentation, such as scene rotations, may also be dynamically applied during training to enforce the robustness of the resulting model.

More precisely, the noise encoder may take as input the level of noise that has been added to the ground truth 3D objects layout and may return a noise encoding token. The 3D object encoder may take as input features representing a 3D object, such as its spatial attributes that have been noised (e.g., its position, rotation and dimensions) as well as other object-level attributes (e.g., semantic category), and may output a 3D object encoding token for each object. The room encoder may take as input features about the 3D room (e.g., its floorplan / shape) and may return a room encoding token. The noise-aware transformer encoder network then may take as input the sequence of above-mentioned tokens and may compute new representations for each of the input tokens. The output tokens, representing 3D objects, may be passed to a final MLP, which may return the denoised 3D object spatial features (e.g., positions and rotations for each 3D object in the sequence). This training is end-to-end: a single loss value may be computed and backpropagated to adjust the weights of all the trainable modules. Setting up the training stage may involve the following sub-tasks.

The first sub-task is the data preprocessing. The annotated 3D scene data samples may be processed so they may conveniently be passed to the relevant modules. This generally involves extracting the different features (e.g., the 3D room floorplan, 3D objects bounding boxes, etc.) from raw scene annotation data and rescaling them to a predefined range of values.

The second sub-task is the design of the architecture. Distinct neural network modules may be designed so they effectively compute rich representations of the different input features that helps denoising the perturbed samples. Also note that the transformer encoder denoiser takes as input fixed-size tensor embedding. It may be followed by a MLP to output the clean predictions of the noisy 3D object spatial features.

The third sub-task is the preconditioning of the score network. Parameterization of the score-based objective may be carefully designed to facilitate learning the underlying data distribution. This may involve performing noise-dependent modulation of the score network's output, as well as scaling of the model's inputs, outputs and noise level.

The fourth sub-task is the choice of the training loss. The training loss function may measure the distance between the 3D object layout predicted from the noisy one and the ground truth, clean layout. This loss function may avoid penalizing predictions where identical objects may have been swapped (e.g., a predicted layout where a pair of identical chairs around a table are swapped compared to the ground truth should not be penalized).

Finally, the last sub-task is the training process. Training may be performed by iterating several times over the dataset (pairs of randomly noised at various scales and clean layouts).

The online stage (or generation, also called sampling or inference) aims at generating natural and precise 3D object layouts via iterative denoising given a set of user-provided conditioning information such as a room's floorplan and a list of object categories. To do so, objects to be arranged within the input floorplan may be arbitrarily initialized (e.g., at the center of the room with random rotation values and arbitrary dimensions). The trained model being noise-conditioned, a state-of-the-art diffusion sampling framework may be employed to recover valid object layouts, by iteratively applying the model conditioned on decreasing noise scales, and for a fixed and reasonable number of steps. The stochastic sampling framework also allows to get various arrangement results from one generation to another. This noise-awareness also easily enables the trained model to perform other tasks at sampling time: to perform re-arrangement, where the target object positions are known not to be far from the noisy one with fixed dimensions, the iterative denoising may be performed starting from a lower noise scale.

The online stage may involve the following sub-tasks.

The first sub-task is to get the conditioning input and initialize noisy features. User-provided conditioning information, such as the target floorplan, may be preprocessed accordingly so they can be passed to the relevant encoders. Spatial object features that are outputted by the score network may be initialized randomly or at arbitrary values.

The second sub-task is to define the sampling algorithm (i.e., the sampler). An efficient sampler may be implemented to generate new samples from the trained score network. This may involve tuning the number of denoising steps, choosing a noise discretization scheme (decreasing values of noise levels), as well as other relevant sampling hyperparameters that are extensively discussed in the literature.

The third sub-task is the sampling process (sometimes also called iterative denoising). The defined sampling process may be performed for a fixed number of steps (e.g., at least 30 steps, fixed means set by a user) by iteratively applying the score network on its own spatial object features output being denoised, starting from the randomly / arbitrarily initialized ones. At each iteration, the current noise level as well as the user-provided conditioning features may also pass to the relevant encoder modules. At the end of the sampling process, 3D object spatial features have converged to their clean predicted values.

The fourth sub-task is the flexible adaptation to multiple tasks. The iterative denoising process may be tuned at inference time depending on the target task. For instance, some spatial object features that are usually predicted by the model may be fixed to predefined values (e.g., by fixing objects to a certain location or by setting their desired dimensions): at each sampling step, the model's prediction may be replaced by the predefined value. These object features, therefore, ultimately may converge to the predefined ones, and the unknown ones being denoised smoothly may be adapted to the predefined values throughout the sampling process. Other tasks may also be performed by tweaking the sampler's parameters. For instance, 3D re-arrangement may be performed by applying iterative sampling starting from a lower noise level, since objects are known not to be far from their target location. Attention weights of the trained transformer may also be leveraged to perform objects grouping.

Finally, the last sub-task is the object retrieval. Generation of a 3D indoor layout may typically be followed by a retrieval phase for actual furnishing of a room with assets from an external 3D database. This retrieval may be, most of the time, performed based on a dissimilarity between the predicted (or provided) dimensions and object dimensions from the external database for a given object category. This process may be inherently sub-optimal because of the mismatch between the predicted / provided object dimensions and those available in the database. To circumvent this limitation, the proposed method may perform additional denoising / sampling "re-arrangement" steps, starting from a noise level that is derived from the mismatch between predicted and retrieved object dimensions, to finely adapt the generated layout to the actual dimensions of furnishing objects.

Implementations of the solution (e.g., according to the example of FIG. 3) are now discussed with reference to FIG.s. 4-18.

An example of implementation focuses on the generation of 3D interior room arrangements: it outputs 3D objects positions and rotations from a list of the objects

represented by their semantic class and 3D dimensions as well as the target room floorplan.

The acquisition S10 (i.e., the obtaining) of a dataset of ground truth 3D layout and the content of the dataset are detailed. The implementation may use data extracted from furnished digital 3D scenes that have been created by various HomeByMe® users. HomeByMe® is a free interior design application, that allows users model their home in 3D, by selecting and precisely placing furniture among an extensive object catalog. Each HomeByMe® project is associated to a rich annotation file that contains various information about the 3D scene (typed object 3D bounding boxes, room's shape, etc.). More formally, the following data elements may be considered:

i. 3D bounding boxes. The annotation file may contain a list of miscellaneous features describing each of the scene's objects. Two of those attributes may be of interest to us: the class of the object and its oriented 3D bounding box. The raw data retrieved from this file defines 3D bounding boxes by two 3D points corresponding to two opposite vertices of the bounding box. There is a total of 174 possible classes in the HomeByMe® dataset.

ii. Room's shape. The room's shape may be stored in the annotation file as a list of 2D points representing the corners of the room.

In accordance with such an implementation, the function has been trained on at least tens of thousands (e.g., 50K scenes), and evaluated on at least a few thousands (e.g., 5k scenes) from the Bedroom subset of the HomeByMe® dataset. The model kept rooms that contain up to 50 objects, which could arguably be considered as densely furnished rooms. Note that the training subset may however be scaled to much larger datasets featuring other types of rooms.

The offline training S40 stage of such an implementation is now detailed.

During the data processing, each scene may be represented as an unordered set of objects, each being represented by its typed 3D bounding box and a floorplan. The data processing may include the 3D bounding box processing, the object's class processing, the floor points sampling, the ground truth scene perturbation and the random data augmentation.

The raw 3D bounding boxes may be converted from a representation based on two opposite vertices to a representation by their position $p \in \mathbb{R}^3$, their orientation (rotation) $r \in \mathbb{R}^2$, and their dimension $d \in \mathbb{R}^3$. In the present implementation, there is only one rotational degree of freedom for the objects present in the scene: their rotation around the vertical axis. As a consequence, only a single angle $\theta$ is needed to properly define the orientation of the bounding box. In practice, a different representation may be used that encodes the orientation of the 3D bounding box by a pair corresponding to $(\cos(\theta), \sin(\theta))$. Such a parametrization is mathematically equivalent to the single value parametrization, but it forces the continuity of the deep learning model for $\theta = 0$ and $\theta = 2\pi$. If continuity of the deep learning model was not forced through this parametrization, the model would have had to learn the continuity which would slow down the convergence of the model. Thus, the processed oriented 3D bounding boxes may be defined by a list of 8 parameters. The position $p$ values may be normalized in [-1,1] (based on the room dimensions, derived from the floor plan extent) during training which is the same range as $\cos(\theta)$ and $\sin(\theta)$. The normalization may be an affine transformation scaling the scene in the right range and centering it. For a scene having $N$ objects, $x$ denotes the spatial features that may be noised and denoised (model output). In implementation, since object positions and rotations are predicted, $x \in \mathbb{R}^{N \times 5}$.

In the example of the implementation, each 3D object from the HomeByMe® dataset is described by a class which provides a broad description (chair, table, door, ...). There is a total of 174 classes in the HomeByMe® dataset. To be fed to the deep learning model, the class of the object may be converted to a one-hot encoded representation $c$ in $\{0,1\}^{174}$. This encoding may be done otherwise (e.g., computing a CLIP text embedding of the class of the object considered as a string, in accordance with the teaching of the paper by Radford, A., Kim, J. W., Hallacy, C., Ramesh, A., Goh, G., Agarwal, S., ... & Sutskever, I. (2021, July). Learning transferable visual models from natural language supervision. In International conference on machine learning (pp. 8748-8763). PMLR).

The present implementation comprises sampling 100 points along the walls of the floorplan so that the borders of the room are represented by a 3D point cloud $\mathcal{F} \in \mathbb{R}^{100 \times 3}$. Alternatively, the floorplan may be represented by an unordered set of 3D points corresponding to its corners. However, such an alternative, is ambiguous and cannot be easily interpreted by the deep neural network.

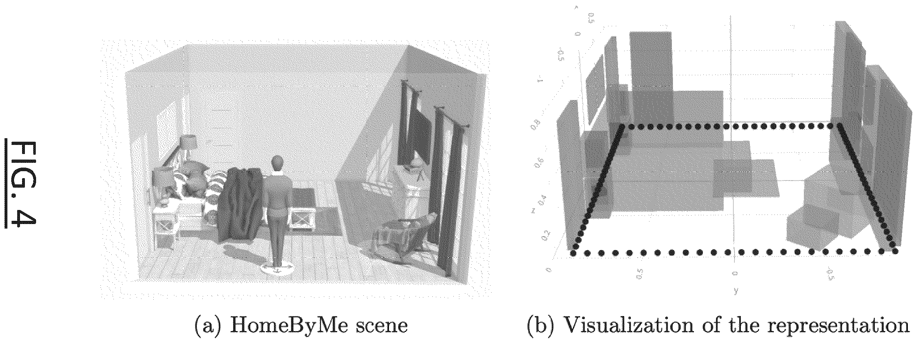

FIG. 4 shows the correspondence between a scene in the HomeByMe® dataset and its preprocessed representation with sampled floor points and typed 3D bounding boxes.

The implementation of the machine learning method comprises obtaining S20 a normal distribution of noise levels. At each training iteration and for each training sample (i.e., for each ground truth 3D layout), the implementation comprises obtaining S30 a respective perturbed 3D layout computable by perturbing at least one parameter of at least one 3D bounding box of the ground truth 3D layout. The perturbing includes sampling S30a a respective noise level $\sigma$, defining the magnitude at which the 3D object positions and rotation values will be perturbed. The respective noise level may be obtained by taking the absolute value of a scalar drawn from a normal distribution: $\sigma\text{-}abs[\mathcal{N}(0, \sigma_s)]$. In the present implementation, $\sigma_s$ is set to 0.23 which is sufficiently high so that, at inference, the trained model is able to generate arrangements from random or arbitrary position values that are possibly far from the target, clean ones. Again, let $x$ be the "clean" ground truth spatial features from the data distribution, the corresponding perturbed "messy" attributes (i.e., parameters) $x_\sigma \in \mathbb{R}^{N \times 5}$ obtained by sampling S30b and adding S30c the respective noise values $\sigma \varepsilon$ with $\varepsilon \sim \mathcal{N}(0, 1)$ to 3D object spatial parameters x. Note that the resulting rotation features r may be then normalized so that $\cos(\theta)$ and $\sin(\theta)$ are still valid (lie in [-1, 1]).

To facilitate generating arrangements for scenes presenting walls that are not aligned with the coordinate axes, that may be rarely represented in the dataset, data augmentation may be performed at training time by rotation the scenes along the vertical axis by a random angle. Data augmentation reduces overfitting of the training data and allows to get a model that is more robust to complex floorplan geometries.

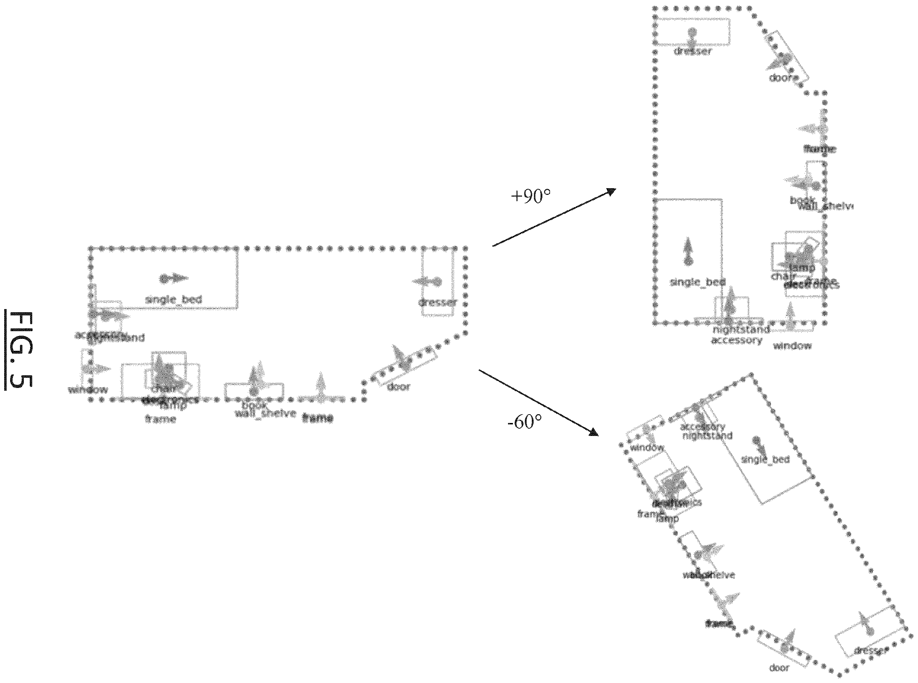

FIG. 5 shows a 2D top view visualization of a scene from the dataset and a pair of rotated versions.

The design of the denoising architecture is now discussed.

The implementation of the deep architecture may be composed of multiple trainable components: the noise encoder (i), the 3D object encoder (ii), the floor encoder (iii), the noise-aware transformer encoder (iv) and the final MLP (v) outputting the predicted object position and rotation values.

The following provides a description of the noise encoder (i).

The sampled noise level $\sigma$ scalar value may be passed through a Positional Encoding (PE) module which deterministically increases the dimension of the scalar value from $\mathbb{R}^1$ to $\mathbb{R}^{64}$. Positional encoding enables the generation of diverse representations of the same scalar value, allowing deep learning models to capture more nuanced information when necessary. In the implementation, the PE may be of the type:

$$PE(x) = \left\{ sin\left(128^{\frac{j}{31}}x\right), cos\left(128^{\frac{j}{31}}x\right) \right\}_{j=0}^{31} \in \mathbb{R}^{64}$$

The PE module may be followed by a trainable MLP that maps the encoding from $\mathbb{R}^{64}$ to $\mathbb{R}^{768}$. The resulting vector may be a token representing the noise level at which the 3D object spatial attributes have been perturbed.

The following provides a description of the 3D object encoder (ii).

The scalar values ($p$, $r$, $d$) which describe each 3D bounding box in the scene may passe through a PE module so they are each represented by a vector in $\mathbb{R}^{64}$.

After the PE modules, the position and dimension of the bounding boxes which are respectively originally described by three scalar values are described by a 192-dimensional vector ($3 \times 64 = 192$). On the other hand, the rotation which is originally described by a pair of scalar values is described by a 128-dimensional vector after the positional encoding. To ensure that the position, dimension and rotation are weighed in similarly by the model, the high dimensional version of the rotation may pass to a multi-layer perceptron which maps it from $\mathbb{R}^{128}$ to $\mathbb{R}^{192}$. This improves the model's convergence.

The one-hot encoded category c is a vector from $\{0,1\}^{174}$. To ensure that the category is weighed in similarly to the position, the dimension and the rotation of the

bounding box, the category vector may pass to a multi-layer perceptron which maps it to $\mathbb{R}^{192}$. It is common practice to apply such transformations to one-hot encoding as they are not considered to be a meaningfully rich representation. During training, conditioning dropout may also be performed on the encoded category, which means that at each iteration, $c$ is replaced by a null token in $0^{174}$. It is empirically found that this mechanism helps reducing overfitting of the training spatial configurations $p_{data}(x)$. It also allows the model to generate new layouts both with and without specifying the object categories $c$ at sampling time.

All the previously computed vectors may be concatenated in a single vector in $\mathbb{R}^{768}$. This vector may be a token representing a typed object 3D bounding box.

Here is a description of the floor encoder (iii). As a reminder, encoding the room's floor point conditions the 3D layout generation so that the resulting 3D objects lie within the floor limits.

The 3D point cloud of sampled floor points $\mathcal{F}$ may be fed to a PointNet module which outputs an embedding vector in $\mathbb{R}^{1024}$. This embedding may itself be fed to a multi-layer perceptron which maps the vector to $\mathbb{R}^{768}$. This final vector may be a token representing a floor plan.

The following provides a description of the noise-aware transformer encoder (iv).

The noise level token, 3D objects tokens and the floor token may all be concatenated to form a sequence of tokens. These tokens may be independent from one another. In order to capture relationships between the different elements of this sequence, a transformer module may be used. Transformer modules require a fixed input size because of their intrinsic architecture. However, the sequence built through the concatenation of the outputs may have a variable length as the number of 3D bounding boxes in a scene varies from a scene sample to another. To be compatible with the Transformer architecture, the sequence may be padded with "zero" tokens ( $0_{\mathbb{R}^{768}}$ ) so that the sequence is of fixed length. Scenes that have less than 50 objects are padded accordingly. The sequence may therefore be represented as a tensor from $\mathcal{M}_{768 \times 52}(\mathbb{R})$. This tensor may be fed to the transformer module, which outputs the final scene embedding tensor of the same dimension. A Boolean padding mask, indicating the indices of the sequence that are padding "zero" tokens, may also be passed to the Transformer as an additional input. This mask may be used in the self-attention mechanism to zero out the attention scores for padding tokens.

The following provides a description of the final MLP (v).

New representations computed by the transformer for each 3D object may be finally passed to an MLP that outputs a tensor $\hat{x}$ in $\mathbb{R}^{N \times 5}$, indicating the predicted "clean" positions $\hat{p}$ and rotations $\hat{r}$ for each 3D object.

The resulting architecture has a total of 12.2 million trainable parameters.

The noise-dependent pre-conditioning of the score network is discussed below.

Let $D_\theta(x_\sigma; y, \sigma)$ be a noise-conditioned denoiser of trainable parameters $\theta$ that maps noisy spatial features $x_\sigma$ to its clean version $x$ and from additional conditioning input $y$. In the present example, the input are the room's floorplan $\mathcal{F}$, the object semantic categories c and dimensions d so that $y = (\mathcal{F}, c, d)$. Instead of predicting such a clean scene from the perturbed input directly, the denoiser's output may be parametrized as a function of a noise-conditioned score network $S_\theta(x_\sigma; y, \sigma)$ that only needs to map a probability (e.g., standard Gaussian) distribution, which is much easier to learn. More precisely, an example of parametrization may be:

$$D_\theta(x_\sigma; y, \sigma) = c_{skip}(\sigma) * x_\sigma + c_{out}(\sigma) * S_\theta\big(c_{in}(\sigma)\, x_\sigma; y, c_{noise}(\sigma)\big)$$

The $c_{skip}$ term performs a $\sigma$-dependent preconditioning and modulates the output to predict the clean spatial features x when $\sigma$ is large, the added noise $\sigma\varepsilon$ when $\sigma$ is small, or something in between. Furthermore, $c_{in}$ and $c_{out}$ scale the noisy position and rotation inputs and outputs to have unit variance. We have:

$$c_{skip} = \frac{\sigma_{data}^2}{\sigma_{data}^2 + \sigma^2} \qquad ; \qquad c_{in} = \frac{1}{\sqrt{\sigma_{data}^2 + \sigma^2}} \; ; \qquad c_{out} = \frac{\sigma \cdot \sigma_{data}}{\sqrt{\sigma_{data}^2 + \sigma^2}}$$

The expression $c_{noise} = \frac{\log \sigma}{4}$ is empirically set. $\sigma_{data}$ is the standard deviation of the training dataset and should be computed offline before training. Considering the 3D scene modality, it seems more thoughtful to compute it channel-wise as, e.g., each channel of object's position has different standard deviation. Considering the strong dependence between an object's position and the dimension of its 3D bounding box (since it often lies on the ground or against a wall), the same $\sigma_{data}$ value may be kept for the position and the dimension of a given axis by taking the root-mean-square of both standard deviations of a common axis, e.g., for the position x coordinate and dimension width w (i.e., the x-axis extent of the bounding box):

$$\hat{\sigma}_{data}^{pos_x} = \hat{\sigma}_{data}^{dim_w} = \sqrt{\frac{\sigma_{data,pos_x}^2 + \sigma_{data,dim_w}^2}{2}}$$

For the rotation, encoded as cos(θ), sin(θ), their $\sigma_{data}$ value may be arbitrarily fixed to unit variance.

Such a parametrization in the present implementation amounts to a trained function which predicts realistic and plausible 3D layouts and which is flexible to be adapted to different usages (e.g., 3D arrangement generation, partial 3D arrangement generation, 3D re-arrangement and the like).

The instance-level Chamfer distance loss is detailed below.

It may be required that the training loss function objective measure the distance between the predicted 3D object spatial attributes (positions and rotations) and the ground truth ones. It may also be required that this loss be invariant to permutations of identical 3D objects, i.e., objects that have the same dimensions and the same semantic category. In this context, it may be proposed a novel semantic-aware Chamfer Distance loss function, which measures the distance between the set of objects $\hat{\mathcal{O}}$ of the predicted scene and the one from the target (ground truth) scene $\mathcal{O}$ :

$$d(\hat{\mathcal{O}}, \mathcal{O}) = \frac{1}{2N}\left(\sum_{\hat{o}\in\hat{\mathcal{O}}} \min_{o\in\mathcal{O}} l(\hat{o}, o) + \sum_{o\in\mathcal{O}} \min_{\hat{o}\in\hat{\mathcal{O}}} l(\hat{o}, o)\right)$$

with:

$$l(\hat{o}, o) = \|\hat{x} - x\|_2^2 + K\big(1 - \delta_d(\hat{o}, o)\,\delta_c(\hat{o}, o)\big)$$

with $K = 10^8$.

If a couple of objects do not have the same category and dimension, a huge penalty is applied, thus excluding them to be returned by the *min* operator. In the case where the object dimensions are predicted, it may be included the distance between predicted and ground truth dimensions and only apply the penalty based on the categories of an object pair.

This loss is way more computationally efficient than the Earth Mover's Distance used in previous works, is inherently differentiable and can be parallelized for fast computation on GPU(s).

As a reminder, during training S40, this distance is computed on predicted versus ground truth layouts from the training distribution $p_{data}(x)$ perturbed by adding noise $\varepsilon \sim N(0,1)$ and at various noise levels $\sigma \sim abs[\mathcal{N}(0, \sigma_s)]$. The corresponding training objective may be:

$$\mathbb{E}_{p_{data}(x),\epsilon,\sigma}[\lambda(\sigma)d(D_\theta(x + \sigma\epsilon; y, \sigma), x)]$$

where $x$ are the spatial features (e.g., object positions and rotations), $y$ is the conditioning information (e.g., the room's floorplan and list of object categories and dimensions), and $\lambda(\sigma)$ is a noise level-dependent weighting function. In practice, it may be set:

$$\lambda(\sigma) = 1/c_{out}^2(\sigma)$$

to get a uniform weighting across noise levels.

Now, a description of the arrangement sampling / inference stage is provided.

Once a score-based denoiser model has been trained (after S40) following the proposed method of machine-learning, it may be used to perform various online tasks at inference time, by obtaining S50 an input 3D layout and a given noise level and by setting up a sampling procedure (i.e., applying S60 the trained function one or more time starting from the input 3D layout to predict an output 3D layout) that may be flexibly tweaked to adapt to different scenarios. A sampler defines how a trained score-based model is iteratively applied in order to generate new realistic samples that resemble the training distribution. Notably, setting up a sampler may generally involve defining a noise level scheduling (i.e., the decreasing noise levels at which the model will be evaluated). 2nd order samplers may involve applying the model twice at each scheduled noise level. Stochastic samplers may also involve injecting fresh noise at each iteration of the iterative denoising process, in order to better explore the space of the learned distribution. Although several sampling strategies may be implemented, here the one that has been retained is described.

The implementation of a 2nd order stochastic sampler helps getting precise generation results while reducing the number of computationally costly neural evaluations (i.e., applications of the model). The following algorithm forms an example of implementing this sampling procedure:

```
1:  procedure STOCHASTICSAMPLER(D_θ(x;σ), t_{i∈{0,...,N}}, γ_{i∈{0,...,N-1}}, S_noise)
2:      sample x_0 ~ N(0, t_0² I)
3:      for i ∈ {0,...,N-1} do                                    ▷ γ_i = { min( S_churn/N , √2−1 )   if t_i ∈ [S_min, S_max]
4:          sample ε_i ~ N(0, S²_noise I)                                  { 0                          otherwise
5:          t̂_i ← t_i + γ_i t_i                                  ▷ Select temporarily increased noise level t̂_i
6:          x̂_i ← x_i + √(t̂_i² − t_i²) ε_i                      ▷ Add new noise to move from t_i to t̂_i
7:          d_i ← (x̂_i − D_θ(x̂_i; t̂_i))/t̂_i                    ▷ Evaluate dx/dt at t̂_i
8:          x_{i+1} ← x̂_i + (t_{i+1} − t̂_i)d_i                   ▷ Take Euler step from t̂_i to t_{i+1}
9:          if t_{i+1} ≠ 0 then
10:             d'_i ← (x_{i+1} − D_θ(x_{i+1}; t_{i+1}))/t_{i+1}   ▷ Apply 2nd order correction
11:             x_{i+1} ← x̂_i + (t_{i+1} − t̂_i)(½d_i + ½d'_i)
12:     return x_N
```

Here, fresh noise may be first added at each iteration, and a gradient step may then be computed from the intermediate position. A 2nd order correction may be taken in order to converge faster. The choice of $t_{i\in\{0,...,N-1\}}$ comes from a decreasing function, from a specified $\sigma_{max}$ when $i = 0$ to a given $\sigma_{min}$ when $i = N - 1$. An example may be of the type:

$$t_{i<N} = \left( \sigma_{max}^{\frac{1}{\rho}} + \frac{i}{N-1}\left( \sigma_{min}^{\frac{1}{\rho}} - \sigma_{max}^{\frac{1}{\rho}} \right) \right)^{\rho} , t_N = 0$$

The $\rho$ parameter may be fine-tuned to dedicate more steps of the denoising process to either smaller or larger noise levels: $\sigma_{min}$ may be set small enough so that the model estimates the best approximation of the true score of the data distribution and sample a precise arrangement, and $\sigma_{max}$ may be set large enough to sample various arrangements. $\gamma_{i\in\{0,...,N-1\}}$ defines the amount of stochasticity (i.e., *fresh* noise) added at the beginning of each step of the denoising process, based on the $S_{churn}$ parameter. It was observed that adding stochasticity in the final denoising steps, i.e., when the sampled arrangement is getting close to its final configuration, leads to less precise results. That is why a threshold $S_{min}$ is set so that when $t_i$ is inferior to $S_{min}$, $\gamma_i = 0$ and no stochasticity is added.

In practice, it is set $\rho = 7$, $S_{noise} = 1.003$ and $S_{churn} = 40$.

FIG. 6 shows a visual representation of a sampling step applied to a single object (e.g., a chair).

The proposed solution may be used for a variety of inference tasks, such as 3D arrangement generation (i), 3D re-arrangement (ii), partial 3D arrangement generation (iii) and attention-based objects grouping (iv).

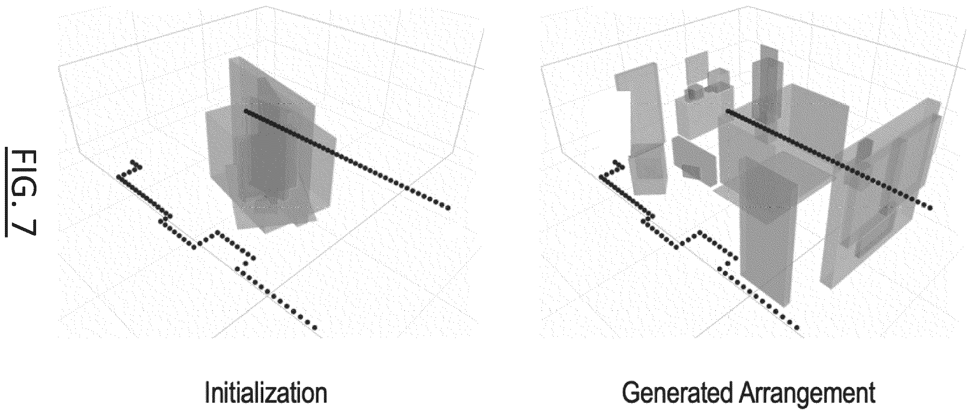

FIG. 7 shows a typical qualitative result by applying the method of use for the task of 3D arrangement generation (i). The task of 3D arrangement generation aims at generating a realistic scene arrangement from an initialized configuration. In order to perform the 3D arrangement generation from a given floorplan and list of 3D objects, the 3D object positions may be arbitrarily initialized at the center of the room and 3D object rotations (i.e. orientations) may be initialized randomly. The denoising process may be performed starting from a sufficiently high value of the noise level (e.g., $\sigma_{max} = 1.0$ or $\sigma_{max} = 0.5$). The number of steps in the iterative sampling may be set to N = 50 steps. Setting a suitable number of steps in the iterative sampling produces a good trade-off between the quality and precision of the 3D scene arrangement and the sampling time.

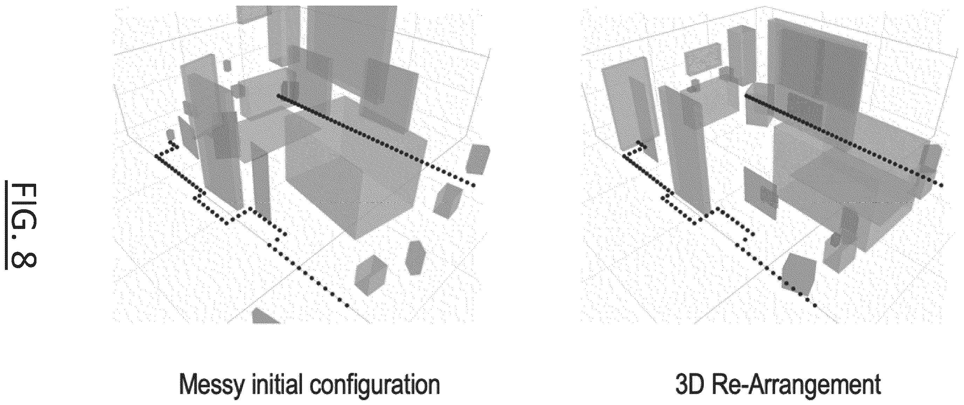

FIG. 8 shows an example of 3D re-arrangement (ii). The task of 3D re-arrangement aims at recovering a realistic arrangement configuration from a messy initial configuration. In order to perform the 3D re-arrangement from a given floorplan and list of 3D objects, the 3D object positions and rotations may be initialized to their messy (i.e., perturbed) values. The denoising process may be performed starting with from a value of the noise level that is lower than the task of 3D arrangement generation.

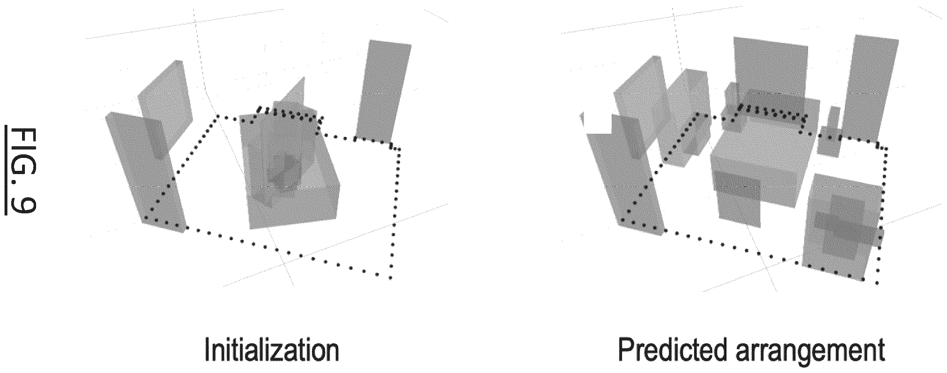

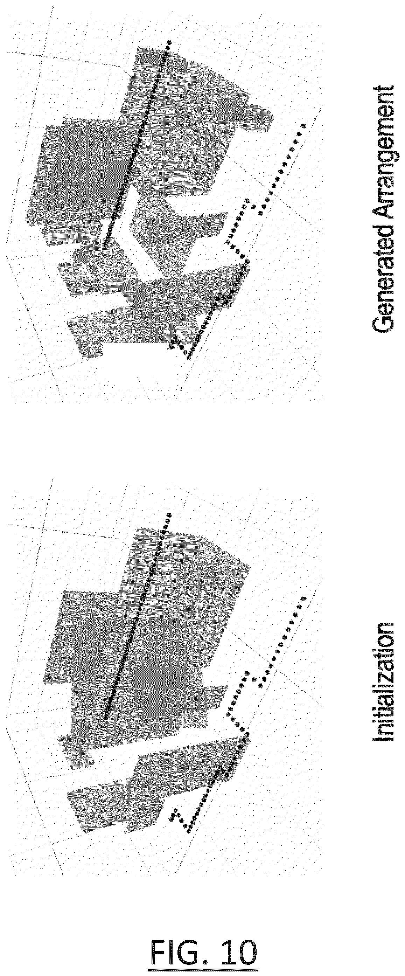

FIG. 9 shows an example of partial 3D arrangement generation. The task of partial 3D arrangement generation aims at generating a realistic scene arrangement from an initialized configuration where some 3D objects have their positions and rotations determined. These objects may be therefore initialized to their known positions and rotations values, while those to be arranged may be again initialized at the center of the room with random rotations values. At each denoising step, the output of the model for the known 3D objects (i.e., the 3D objects with known values of their positions and rotations parameters) may be replaced by their original position $p$ and orientation $r$ values. Note that instead, the output of the model for the known 3D objects may be replaced by their position $p_\sigma$ and rotation $r_\sigma$ values that have been noised at a level $\sigma$ corresponding to the current sampling step. Either case, these known objects ultimately converge to their initial values throughout the sampling process. FIG. 10 shows an example of partial 3D arrangement generation with more 3D objects fixed to their determined values of positions and rotations.

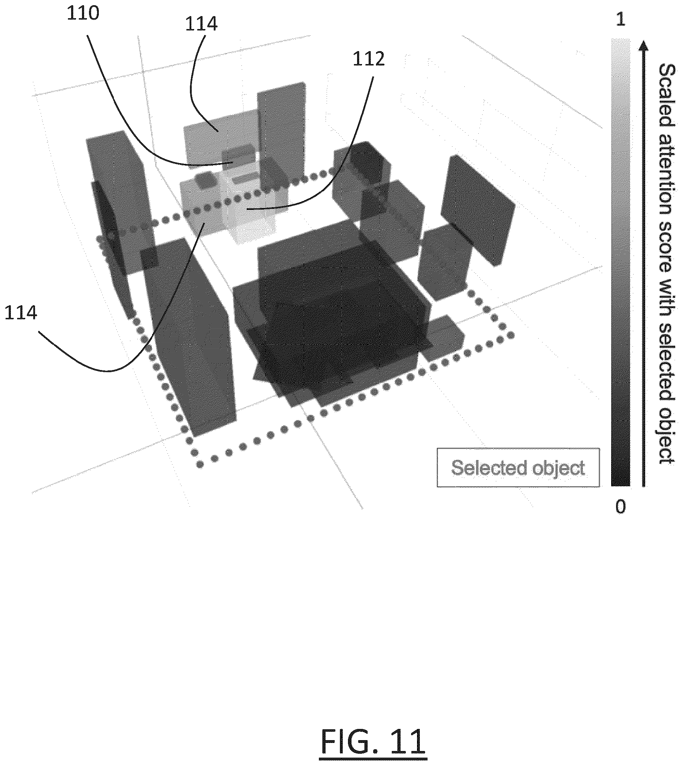

FIG. 11 shows an attention map for a selected electronic device 110 (on a desk 112). As the trained function features a transformer encoder module that processes 3D object tokens, attention scores between a given 3D object and

18

each of the other ones in the scene may be computed. Scores may be computed based on the last transformer layer and averaged across its attention heads. The 3D objects 112, 114 that are close and related to the 3D object of interest have higher attention scores. For example, still with reference to the FIG. 11, the selected 3D object 110 is placed on a table 112 and the other 3D objects 114 grouped close to the selected object. This indicates that the transformer model has successfully learned the relationships between 3D objects, and that a threshold can dynamically be defined to determine the set of 3D objects that will be grouped to the selected 3D object so they may, e.g., be moved altogether. Note that for a given 3D object, computing a score based on another transformer layer may produce other meaningful groups.

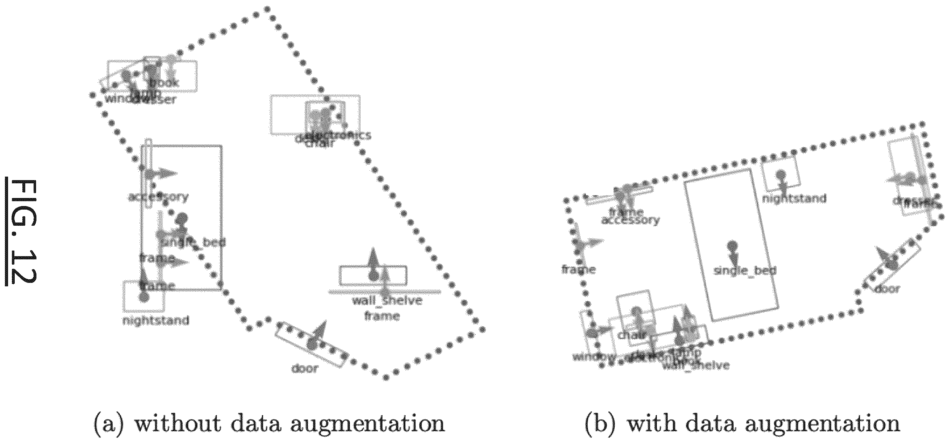

FIG. 12 shows a comparison between a result obtained by using a function trained without data augmentation (left panel) and a result obtained by using a function trained with data augmentation (right panel). The 3D scene arrangement generated with data augmentation is more realistic and plausible than the 3D scene arrangement obtained by using a function trained without data augmentation. For example, it is clear that the 3D scene arrangement obtained without data augmentation during training predicts a bed partially outside the given floorplan and a wall shelf in the middle of the room. These inconsistencies are better resolved by data augmentation.

The proposed method is now qualitatively compared with solutions developed based on the state of the art. A quantitative comparison will follow afterwards.

For the purpose of the comparison, an adaptation of an existing state-of-the-art method (originally developed for another task) was constructed. This state-of-the-art method is LEGO-Net, that has been originally proposed for the task of 2D re-arrangement. For the sake of the qualitative comparison, therefore, LEGO-Net model may be trained on the same dataset (e.g., HomeByMe's dataset) and may be adapted for the task of 3D arrangement generation. In particular, the original LEGO-Net model may be tweaked to set a high initial noise in the sampler.

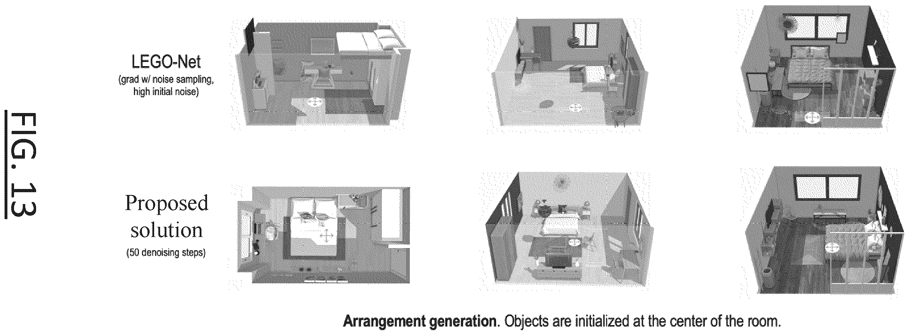

FIG. 13 shows a qualitative comparison between an adapted version of LEGO-Net and the proposed solution. The results are exported to the HomeByMe application with the sole purpose to get a better 3D visualization. For the task of 3D arrangement generation, the 3D objects may be initialized at the center of the room with random rotations. The adapted LEGO-Net model may perform a sampling with high initial noise, whereas the proposed solution may perform a iterative sampling with 50 denoising steps. The comparison of the results shows that the proposed solution achieves more realistic and natural-looking 3D scene arrangements. In examples, the proposed method (second row of FIG. 13) generates realistic and natural-looking (i.e., plausible) 3D arrangements, whereas the adapted LEGO-Net (first row of FIG. 13) generates 3D scene arrangements with clear unrealistic and inconsistent results. For example, the first result in the first line shows a floating bed over the garderobe. Moreover, the generation time of LEGO-Net is much higher than the proposed solution, the reason being that the sampling procedure implemented in LEGO-Net does not guarantee convergence for a fixed number of iterations. In other words, the iterative denoising is performed until 3D objects do not move anymore, thus making LEGO-Net less efficient with respect to the proposed solution.

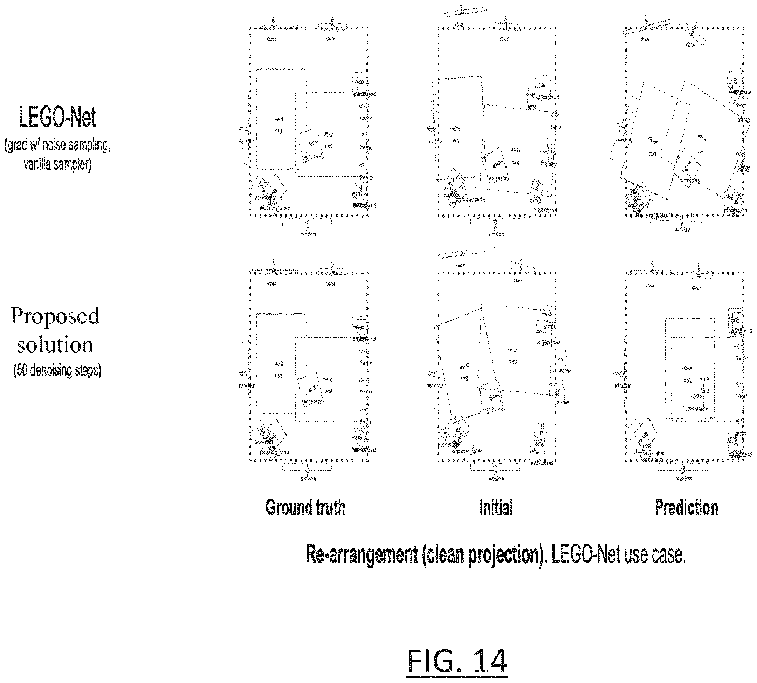

With reference to FIG. 14, it is shown another qualitative comparison between results predicted by LEGO-Net and the proposed solution for the task of 3D re-arrangement. The task of 2D re-arrangement is the original case of LEGO-Net. The FIG. 14 shows the same ground truth scene arrangement that may be initialized to their messy (i.e., perturbed) values of positions and rotations. The LEGO-Net may perform its original sampling, while the proposed solution may perform the iterative sampling with 50 denoising steps. The respective predictions are quite different. The proposed solution predicts a tide arrangement, where objects are consistently (semantically and physically) grouped. For example, the bed is correctly aligned with the wall, the two nightstands are placed at the two sides of the bed frame a dressing table is located on a corner of the floorplan. On the contrary, the prediction of LEGO-Net shows important inconsistencies and does not look natural: the bed is still randomly oriented and the nightstands are not well placed.

Hereafter, a more quantitative comparison is performed.

Generative models are inherently challenging to quantitatively evaluate. However, custom metrics asses the quality of generated arrangements with respect to some indicators measuring the validity and ergonomics of the generated scene. Computing these indicators (i.e., metrics) both on the training set and a fair number of generated arrangements provide insights on the practical performance of the proposed model and evaluate the realism and the diversity of the generated arrangements.

An indicator may be the openings clearance which determines if there is enough free space in front of doors and windows to be opened or passed through (clearance metric). To determine so, a virtual 3D bounding box having the dimension of a door or window is placed in front of it. Its depth may be set to the width of the associated door or window. The Intersection over Union (IoU) between the virtual box and the 3D bounding boxes of the scene's objects may be then computed. The variety of generated arrangements obtained using the proposed model may also be leveraged to automatically select, for a given scene, the best performing one with respect to one or several metrics.

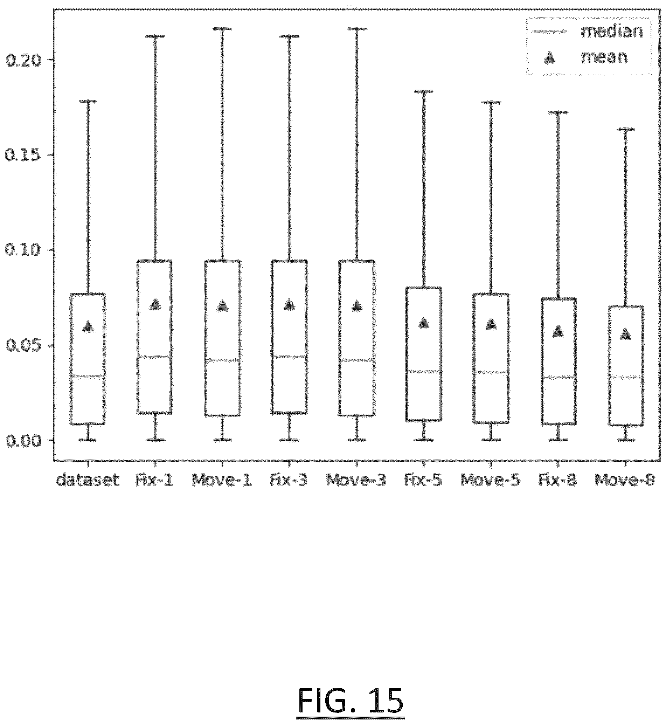

FIG. 15 shows values for the best-performing door and window clearance metric of different trial arrangements (generated arrangements of a given scene), as a function of the number of trials and for two different settings: doors and windows may be fixed (fix) or are arranged as any other objects (move). The metric may be computed every time on 2048 scenes and may be compared to the dataset baseline value. The results of FIG. 15 provide two observations. First, they showcase the variety of the proposed model's output domain: scaling the number of trials may have a clear impact on the metric, showing that generated arrangements are different, for a given scene, across several generations. Second, generating a few trial arrangements may help getting performance that are on par with the training data on this metric. Thanks to the efficient batching and parallelization capabilities of the proposed model, it may also be done at almost no cost.

Another quantitative indicator may be the presence of objects that are out of the bounds. To assess that the floorplan geometry is correctly taken into consideration, it is relevant to compute the mean area of 3D objects that are out of bound (e.g., out of the given floorplan) and the frequency at which 3D objects are at least partially outside the floorplan. In formulae, these two indicators may be given by:

$$Area\ outside = \frac{1}{N}\sum_{i=1}^{N} Area\big(bbox_i \cap \overline{floorplan}\big)$$

and

$$Frequency\ outside = \frac{1}{N}\sum_{i=1}^{N} \mathbb{1}_{Area(bbox_i \cap \overline{floorplan})>0}$$

where $N$ is the number of 3D objects in the arrangement.

A useful quantitative indicator may be the number of conflicting objects. Within the floorplan, conflicts between objects (e.g., collisions, penetrations, overlapping) may breaks the perceived validity of the scene. To estimate their significance, the 3D IoU may be of the type:

$$IoU\ conflict = \frac{2}{N(N-1)}\sum_{i=1}^{N}\sum_{j=i+1}^{N} \frac{Volume\big(bbox_i \cap bbox_j\big)}{Volume\big(bbox_i \cup bbox_j\big)}$$

To get the number of conflicts, the following procedure may be taken. Let S and C be respectively the set of object 3D bounding boxes and the empty set Ø. The object bounding box in S that is conflicting with the greater number of other objects bounding boxes in S is identified, removed from S and added in C. As S is finite, this operation can be done until there are no more conflicting objects in S. The count is then finally the number of elements in C, i.e., |C|. It is important to keep in mind that some collisions, penetrations and overlapping between objects are perfectly valid (e.g., books arranged within a shelf), therefore these metrics may be compared to a baseline such as the dataset values to be correctly interpreted.

Finally, another quantitative indicator may be the variety of a scene arrangement which may be evaluated by the Chamfer distance between a pair of generated layouts. This evaluation may be performed on a fair number of samples (e.g., 2048 scenes). The higher the Chamfer distance, the more diverse the generated layouts may be.

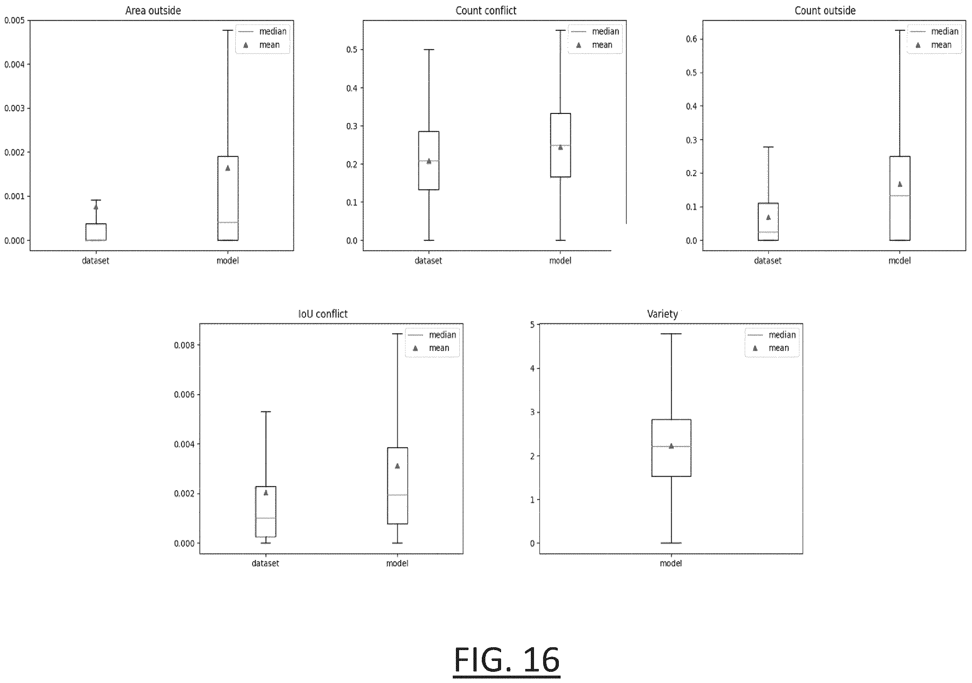

FIG. 16 shows the results of the above-mentioned indicators, evaluated over 2048 scenes for a single generation trial, compared to the dataset values.

The proposed solution may also be trained to predict positions, rotations and dimensions of 3D objects from a given floorplan and a list of semantic objects on the publicly available 3D-Front dataset (available at the following URL at the priority date of the present patent application: https://tianchi.aliyun.com/specials/promotion/alibaba-3d-scene-data set) and compared against established baseline methods, such as LayoutGPT, ATISS and DiffuScene. During the training, the set of conditioning inputs $y$ may comprise only the given floorplan and the given list of semantic categories, i.e., $y = (\mathcal{F},$ c). For the training of these models, the conditioning dropout on the semantic categories may be implemented. The conditioning dropout consists of replacing the given list of semantic categories with a list of zeroes (i.e., a tensor containing zero in its entries) with a predetermined probability (e.g., equal to 0.2). Out of the available room types in the 3D-Front dataset, only living rooms and dining rooms are considered, because they are more densely furnished and feature complex floorplan geometries. The preprocessing steps, according to ATISS, may lead to train/test spits of 2338/587 for the living room and of 2071/516 for the dining room. The indicators to evaluate the realism and the diversity of the generated 3D layouts may be the $256^2$ Fréchet Inception Distance (FID), Kernel Inception Distance (KID x 1000) and the Scene Classification Accuracy (SCA) computed on top-down orthographic renderings. The generation spatial validity may be further assessed by reporting the cumulated out-of-bound objects area (OBA $m^2$). All the metrics may be computed across each test subset. FID and KID compare the distributions of visual features extracted from a pretrained convolution neural network. SCA measures how a convolutional neural network discriminates real scenes (i.e., the ground truth test scenes) from the generated ones, in a binary classification task. Therefore, a SCA score closer to 50% is better, meaning that generated scenes are indistinguishable from real scenes.

Table 1 shows a quantitative comparison for bounded 3D layout generation (providing a given floorplan and a given list of semantic categories of the 3D objects). The comparison features results of the proposed solution against the results obtained from a training-free LayoutGPT and other learning-based approaches (ATISS and DiffuScene). The comparison shows that the proposed solution largely outperforms other baseline methods while consistently generating more realistic and diverse scene arrangements.

Table 1: Quantitative indicators comparing the proposed solution with other methods for bounded 3D layout generation.

| Methods | Living Rooms | | | | Dining Rooms | | | |
|---|---|---|---|---|---|---|---|---|
| | FID | KID | SCA | OBA | FID | KID | SCA | OBA |
| LayoutGPT | 35.53 | 13.69 | 72.8 | 2913.6 | 32.80 | 8.99 | 67.6 | 2447.4 |
| ATISS | 25.67 | 8.91 | 71.8 | 857.3 | 28.05 | 9.26 | 63.2 | 702.4 |
| DiffuScene | 21.54 | 6.40 | 69.7 | 341.1 | 23.06 | 5.35 | 57.7 | 266.4 |
| Proposed solution | 18.89 | 3.57 | 68.3 | 167.8 | 22.04 | 4.41 | 52.4 | 132.8 |

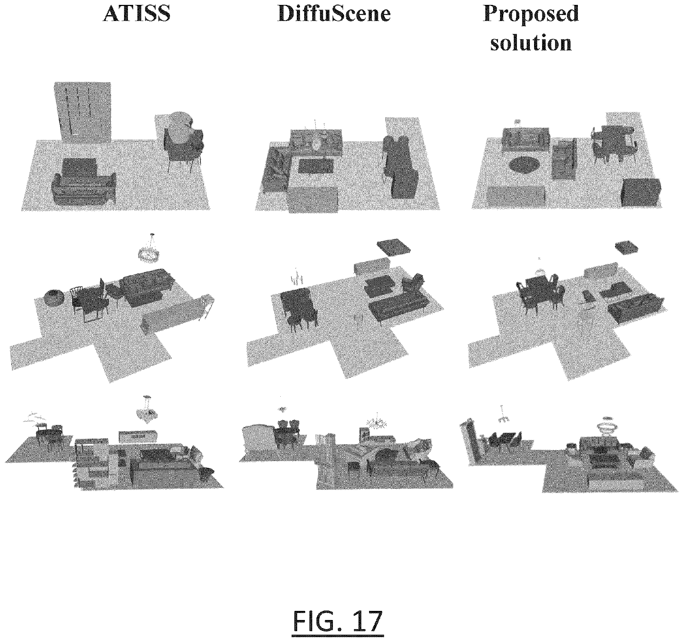

FIG. 17 shows a comparison of results obtained by ATISS, DiffuScene and the proposed solution which features the generated arrangements with scene's floorplan and 3D objects according to their semantic categories. The proposed solution produces the most realistic and diverse 3D arrangement layouts.

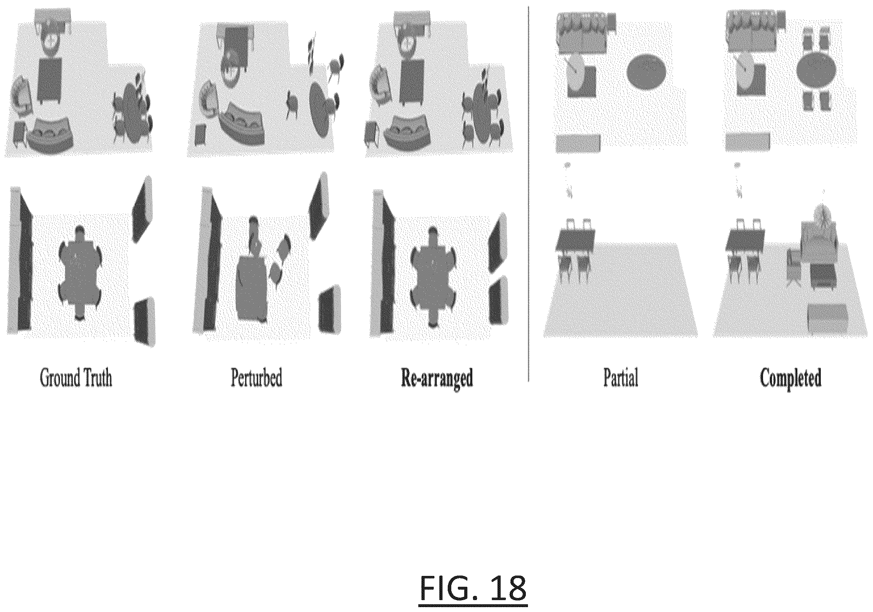

FIG. 18 shows the results obtained by the proposed solution to perform the task of 3D re-arrangement from a messy configuration (depicted in the left panel) and the completion of a partial arrangement (depicted in the right panel).

In Table 2 is reported the number of network parameters for each method and generation time averaged on the 3D-FRONT Living room test subset:

Table 2: Network parameters and generation times.

| Method | Network Parameters ($10^6$) | Generation Time (seconds) |
|---|---|---|
| ATISS | 36.1 | 0.160 |
| DiffuScene | 89.7 | 32.796 |
| Proposed solution | 12.2 | 0.488 |

The architecture of the proposed solution is more lightweight and combined with the efficient sampling procedure, it allows to produce novel layouts faster than denoising-based methods in the prior art.

The learning method is a method of machine-learning of a model, which is a deep generative model. As known *per se* from the field of machine-learning, the processing of an input by a model includes applying operations to the input, the operations being defined by data including weight values or parameters. Learning a model (*e.g.* a neural network or a regressor) thus includes determining values of the weights/parameters based on a dataset configured for such learning, such a dataset being possibly referred to as a learning dataset or a training dataset. For that, the dataset includes data pieces each forming a respective training sample or training example. The training samples/examples represent the diversity of the situations where the model is to be used after being learnt. Any training dataset herein may comprise a number of training samples/examples higher than 1000, 10000, 100000, or 1000000. In the context of the present disclosure, by "training is performed over the dataset", it is meant that the dataset is a learning/training dataset of the model, based on which the values of the weights/parameters are set. In the present disclosure, the training dataset is the obtained dataset of training examples, on which the deep generative model is learnt/trained. In implementations, the training dataset consists of several hundreds of examples each corresponding to a different HPP configuration.

As known *per se* from machine-learning, a neural network may be defined by its architecture, parameters, and hyperparameters. The architecture consists of layers, starting with the input layer whose neuron count may be determined by the dimensionality of the input data. This layer is followed by several hidden layers with a given number of neurons and activation functions. These layers and neurons define the network's depth and width, while the activation functions may introduce nonlinearity into the model. The output layer may have as many neurons as the variables in the output data. The interconnections between these layers defines the topology of the neural network. The parameters of the neural network are the learnable weights and biases, which are determined in the training process. In contrast, the hyperparameters are pre-defined settings that are not learned from the training data. These encompasses the number of hidden layers, neurons per layer and much more. To train a neural network, at least two settings may be defined. First, a loss function, which is a metric that measures the error between the training data and the model's prediction, such as the mean square error (MSE). Second, an optimizer, which modifies the model's weights and biases during the training process to minimize the loss function. Each optimizer has its own set of hyperparameters.

The methods are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

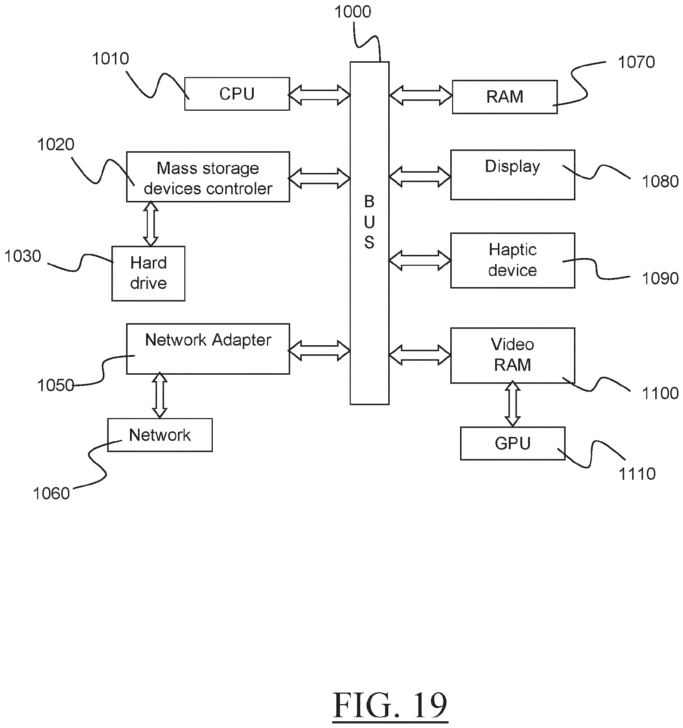

FIG. 19 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the methods. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the methods by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the methods to be performed on the cloud computing environment.

## Claims

1. A computer-implemented method of machine-learning, the method comprising:

   - obtaining (S10) a dataset of ground truth 3D layouts, each ground truth 3D layout representing a respective scene and including:

• a respective floorplan,
• a respective 3D arrangement of one or more 3D bounding boxes, each bounding box being defined by a value of a predetermined set of one or more parameters, and
• for each 3D bounding box, a respective semantic category;

- obtaining (S20) a probability distribution of noise levels;
- for each ground truth 3D layout, obtaining (S30) a respective perturbed 3D layout computable by perturbing at least one parameter of at least one 3D bounding box of the ground truth 3D layout, the perturbing including:

• sampling (S30a) a respective noise level based on the probability distribution; and
• for each respective parameter of the at least one parameter:

◦ sampling (S30b) a respective noise value based on the respective noise level; and
◦ applying (S30c) the respective noise value to the respective parameter; and

- training (S40) a function configured:

• for taking an input 3D layout and a given noise level, the input 3D layout including:

◦ a given floorplan,
◦ a first 3D arrangement of one or more given 3D bounding boxes, each bounding box being defined in the first 3D arrangement by a first value of the predetermined set of one or more parameters, and
◦ for each given 3D bounding box, a given semantic category, and

• for predicting an output 3D layout, the output predicted 3D layout including:

o the given floorplan,
o a second 3D arrangement of the one or more given 3D bounding boxes, each bounding box being defined in the second 3D arrangement by a second value of the predetermined set of one or more parameters, and
o for each given 3D bounding box, the given semantic category,

the function being configured to predict a second value of the predetermined set of one or more parameters different from the first value of the predetermined set of one or more parameters;
the training being performed over the dataset based on a loss which penalizes a dissimilarity metric between each ground truth 3D layout and a respective predicted 3D layout obtainable by applying the function to the respective perturbed 3D layout.

2. The method of claim 1, wherein the dissimilarity metric is of the type:

$$d(\hat{\mathcal{O}}, \mathcal{O}) = \frac{1}{2N}\left( \sum_{\hat{o} \in \hat{\mathcal{O}}} \min_{o \in \mathcal{O}} l(\hat{o}, o) + \sum_{o \in \mathcal{O}} \min_{\hat{o} \in \hat{\mathcal{O}}} l(\hat{o}, o) \right)$$

where:

• $\mathcal{O} = \{o_1, o_2, ..., o_N\}$ is the set of the one or more 3D bounding boxes in a ground truth 3D layout,

• $\hat{\mathcal{O}} = \{\hat{o}_1, \hat{o}_2, ..., \hat{o}_N\}$ is the set of the one or more 3D bounding boxes in the respective predicted 3D layout,

• N is the common size of $\mathcal{O}$ and $\hat{\mathcal{O}}$, and
• $l(.,.)$ is a differentiable distance.

3. The method of claim 2, wherein the differentiable distance penalizes a dissimilarity in dimensions and/or in the semantic category between 3D bounding boxes, and for example is of the type:

$$l(\hat{o}, o) = \|\hat{x} - x\|_2^2 + K\left(1 - \delta_d(\hat{o}, o)\,\delta_c(\hat{o}, o)\right)$$

where:

- $\hat{x}$, respectively $x$, is a vector of values of spatial parameters of $\hat{o}$, respectively $o$,
- $\|\cdot\|_2^2$ is the Euclidean norm,
- $K$ is a penalty parameter,
- $\delta_d(\hat{o}, o)$ is an indicator function equal to 1 when its arguments $\hat{o}$ and $o$ have same dimensions, 0 otherwise, and
- $\delta_c(\hat{o}, o)$ is an indicator function equal to 1 when its arguments $\hat{o}$ and $o$ have a same semantic category, 0 otherwise.

4. The method of any one of claims 1 to 3, wherein the loss of the trained function is an expectation value (

$$L(\hat{\mathcal{O}}, \mathcal{O}) = \mathbb{E}_\sigma\left[\lambda(\sigma)\,d(\hat{\mathcal{O}}, \mathcal{O})\right]$$ ) of the product ($\lambda(\sigma)\,d(\hat{\mathcal{O}}, \mathcal{O})$) between the dissimilarity metric ($d(\hat{\mathcal{O}}, \mathcal{O})$) and a noise-dependent weighting function ($\lambda(\sigma)$).

5. The method of any one of claims 1 to 4, wherein the function comprises a transformer which:

   - takes as input a concatenation of: a representation of the given noise-level, a first representation of each given 3D bounding box, and a representation of the given floorplan, and
   - outputs a representation of the predicted 3D layout, including a second representation of each given 3D bounding box.

6. The method of claim 5, wherein the function further comprises:

   - a noise encoder which generates the representation of the given noise level,
   - a 3D object encoder which generates the first representation of each given 3D bounding box, wherein optionally the 3D object encoder is configured for generating a respective representation of each parameter and a representation of the semantic category, and for concatenating all the generated representations, and/or
   - a floor encoder which generates the representation of the given floorplan, wherein optionally the floor encoder includes a sampling module for generating a sampling from the given floor plan, and a point-cloud encoder for processing the sampling.

7. The method of claim 5 or 6, wherein the function further includes a multilayer perceptron which takes as input the representation of the predicted 3D layout and outputs a third representation of each given 3D bounding box.

8. The method of claim 5, wherein the function is parametrized as follows:

$$D_\theta(x_\sigma; y, \sigma) = c_{skip}(\sigma) * x_\sigma + c_{out}(\sigma) * S_\theta\big(c_{in}(\sigma)x_\sigma; y, c_{noise}(\sigma)\big),$$

where:

   - $x_\sigma$ is the first 3D arrangement of one or more given 3D bounding boxes,
   - $y$ represents the given floorplan, the given semantic category of each of the one or more given 3D bounding boxes, and dimensions of each of the one or more given 3D bounding boxes,
   - $\sigma$ is the given noise level,
   - $S_\theta(c_{in}(\sigma)x_\sigma; y, c_{noise}(\sigma))$ is a noise-conditioned score network having a set of trainable parameters $\theta$,
   - $c_{skip}(\sigma)$ is a noise-dependent pre-conditioning coefficient modulating the predicted 3D layout,
   - $c_{noise}(\sigma)$ is a noise-dependent coefficient which conditions the noise level within the score network, and
   - $c_{in}(\sigma)$ and $c_{out}(\sigma)$ are two noise-dependent coefficients that scale, respectively, $x_\sigma$ and $S_\theta(c_{in}(\sigma)x_\sigma; y, c_{noise}(\sigma))$.

9. A computer-implemented method of use of a function trained according to the method of any one of claims 1 to 8, wherein the method of use comprises:

   - obtaining (S50) an input 3D layout and a given noise level, the input 3D layout including:

o a given floorplan,

o a first 3D arrangement of one or more given 3D bounding boxes, each bounding box being defined in the first 3D arrangement by a first value of the predetermined set of one or more parameters, and

o for each given 3D bounding box, a given semantic category, and

• applying (S60) the trained function one or more times starting from the input 3D layout to predict an output 3D layout, the output 3D layout including:

o the given floorplan,

o a second 3D arrangement of the one or more given 3D bounding boxes, each bounding box being defined in the second 3D arrangement by a second value of the predetermined set of one or more parameters, and

o for each given 3D bounding box, the given semantic category.

10. The method of claim 9, wherein applying the trained function one or more times comprises iterating:

• injecting (S60a) a noise to the input 3D layout, thereby obtaining a perturbed input 3D layout;

• applying (S60b) the trained function at least once to the perturbed input 3D layout, thereby obtaining an output 3D layout; and

• using (S60c) the output 3D layout as the input of a next iteration.

11. The method of claim 10, wherein the noise has a level which decreases with the depth in the iteration.

12. The method of any one of claims 9 to 11, wherein applying the trained function at least once comprises, at each iteration:

• applying (S70a) the trained function to the perturbed input 3D layout, thereby obtaining a first output 3D layout;

• obtaining (S70b) a first intermediate 3D layout by computing a gradient step between the perturbed input 3D layout and the first output 3D layout;

• applying (S70c) the trained function to the first intermediate3D layout, thereby obtaining a second output 3D layout; and

• obtaining (S70d) a second intermediate 3D layout by computing a gradient step between the perturbed input 3D layout and the second output 3D layout, thereby obtaining a final 3D layout.

13. A data structure comprising:

a computer program comprising instructions for performing the method of any of claims 1 to 8 and/or the method of use of any of claims 9 to 12; and/or a function having been trained by a method according to any one of claims 1 to 8.

14. A computer readable storage medium having recorded thereon the data structure of claim 13.

15. A system comprising a processor coupled to a memory, the memory having recorded thereon the data structure of claim 13.

| obtaining a dataset of ground truth 3D layouts | S10 |

| obtaining a probability distribution of noise levels | S20 |

for each ground truth 3D layout, obtaining a respective perturbed 3D layout: — S30

| sampling a respective noise level based on the probability distribution | S30a |

for each respective parameter of the at least parameter:

| sampling a respective noise value based on the respective noise level | S30b |

| applying the respective noise value to the respective parameter | S30c |

training a function for: — S40

- taking an input 3D layout and a given noise level

- predicting an output 3D layout

## FIG. 1

obtaining an input 3D layout and a given noise level — S50

applying the trained function one or more times starting from the input 3D layout to predict an output 3D layout — S60

## FIG. 2a

injecting a noise to the input 3D layout, thereby obtaining a perturbed input 3D layout — S60a

applying the trained function at least once to the perturbed input 3D layout, thereby obtaining an output 3D layout — S60b

using the output 3D layout as the input of a next iteration — S60c

## FIG. 2b

applying the trained function to the perturbed input 3D layout, thereby obtaining a first output 3D layout — S70a

obtaining a first intermediate 3D layout by computing a gradient step between the perturbed input 3D layout and the first output 3D layout — S70b

applying the trained function to the first intermediate 3D layout, thereby obtaining a second output 3D layout — S70c

obtaining a second intermediate 3D layout by computing a gradient step between the perturbed input 3D layout and the second output 3D layout, thereby obtaining a final 3D layout — S70d

## FIG. 2c

Figure 1.
Training Pipeline

FIG. 3

(b) Visualization of the representation

(a) HomeByMe scene

FIG. 4

FIG. 5

FIG. 6

Generated Arrangement

Initialization

FIG. 7

3D Re-Arrangement

Messy initial configuration

FIG. 8

Predicted arrangement

Initialization

FIG. 9

Generated Arrangement

Initialization

FIG. 10

FIG. 11

(a) without data augmentation

(b) with data augmentation

FIG. 12

LEGO-Net (grad w/ noise sampling, high initial noise)

Proposed solution (50 denoising steps)

Arrangement generation. Objects are initialized at the center of the room.

FIG. 13

LEGO-Net
(grad w/ noise sampling, vanilla sampler)

Proposed solution
(50 denoising steps)

Ground truth          Initial          Prediction

Re-arrangement (clean projection). LEGO-Net use case.

FIG. 14

## FIG. 15

FIG. 16

ATISS          DiffuScene          Proposed
                                    solution

FIG. 17

FIG. 18

FIG. 19

Europäisches
Patentamt

European
Patent Office

Office européen
des brevets

**EUROPEAN SEARCH REPORT**

**Application Number**

EP 24 30 6557

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SIYI HU ET AL: "Mixed Diffusion for 3D Indoor Scene Synthesis", ARXIV.ORG, CORNELL UNIVERSITY LIBRARY, 201 OLIN LIBRARY CORNELL UNIVERSITY ITHACA, NY 14853, 31 May 2024 (2024-05-31), XP091774092, * abstract * * page 1 * * page 3 - page 9 * * page 14 - page 18 * ----- | 1-15 | INV. G06F30/13 G06F30/27 G06N3/045 |
| X | JIAPENG TANG ET AL: "DiffuScene: Denoising Diffusion Models for Generative Indoor Scene Synthesis", ARXIV.ORG, CORNELL UNIVERSITY LIBRARY, 201 OLIN LIBRARY CORNELL UNIVERSITY ITHACA, NY 14853, 12 March 2024 (2024-03-12), XP091692918, * abstract * * page 1 - page 8 * * page 13 - page 15 * ----- | 1-15 | |
| X | QIUHONG ANNA WEI ET AL: "LEGO-Net: Learning Regular Rearrangements of Objects in Rooms", ARXIV.ORG, CORNELL UNIVERSITY LIBRARY, 201 OLIN LIBRARY CORNELL UNIVERSITY ITHACA, NY 14853, 23 January 2023 (2023-01-23), XP091419569, * abstract * * page 1 - page 6 * ----- -/-- | 1-15 | TECHNICAL FIELDS SEARCHED (IPC) G06F G06N |

The present search report has been drawn up for all claims

| Place of search | Date of completion of the search | Examiner |
|---|---|---|
| Munich | 21 February 2025 | Radev, Boyan |

EPO FORM 1503 03.82 (P04C01)

Europäisches
Patentamt

European
Patent Office

Office européen
des brevets

# EUROPEAN SEARCH REPORT

**Application Number**

EP 24 30 6557

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GUANGYAO ZHAI ET AL: "CommonScenes: Generating Commonsense 3D Indoor Scenes with Scene Graphs", ARXIV.ORG, CORNELL UNIVERSITY LIBRARY, 201 OLIN LIBRARY CORNELL UNIVERSITY ITHACA, NY 14853, 16 October 2023 (2023-10-16), XP091636799, * abstract * * page 1 - page 8 * ----- | 1-15 | |

**TECHNICAL FIELDS SEARCHED (IPC)**

The present search report has been drawn up for all claims

| Place of search | Date of completion of the search | Examiner |
|---|---|---|
| Munich | 21 February 2025 | Radev, Boyan |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RADFORD, A.** ; **KIM, J. W.** ; **HALLACY, C.** ; **RAMESH, A.** ; **GOH, G.** ; **AGARWAL, S.** ; **SUTSKEVER, I.** Learning transferable visual models from natural language supervision. *International conference on machine learning*, July 2021, 8748-8763